# EUROPEAN PATENT SPECIFICATION

(11) **EP 4 506 776 B1**
(45) Date of publication and mention of the grant of the patent: **03.06.2026**
(21) Application number: 22936611.7
(22) Date of filing: 07.04.2022
(51) Int. Cl.: G06F 1/16, H10K 71/00, G09F 9/302, G09F 9/33, G09F 9/30, H10K 59/126

(54) **DISPLAY DEVICE**
ANZEIGEVORRICHTUNG
DISPOSITIF D'AFFICHAGE

(43) Date of publication of application: 12.02.2025
(73) Proprietor: LG Electronics Inc., Yeongdeungpo-gu Seoul 07336 (KR)
(72) Inventor: KEUM, Kitae, Seoul 06772 (KR); TAK, Junseok, Seoul 06772 (KR); KIL, Hyongil, Seoul 06772 (KR); LEE, Minook, Seoul 06772 (KR)
(74) Representative: Frenkel, Matthias Alexander
(86) International application number: PCT/KR2022/005034
(87) International publication number: WO 2023/195557

(56) References cited:
- KR-A- 19990 068 815
- KR-A- 20090 073 764
- KR-A- 20090 115 315
- KR-A- 20170 089 113
- KR-A- 20180 076 543
- KR-A- 20190 048 029
- KR-A- 20210 094 933
- US-A1- 2020 043 388

## Description

### [TECHNICAL FIELD]

The present disclosure relates to a display device. More particularly, the present disclosure relates to a display device including a transparent display panel.

### [BACKGROUND ART]

As information society develops, the demand for display devices is also increasing in various forms. In response to this, various display devices such as Liquid Crystal Display Device (LCD), Plasma Display Panel (PDP), Electroluminescent Display (ELD), Vacuum Fluorescent Display (VFD), and Organic Light Emitting Diode (OLED) have been researched and used in recent years.

Among these, a liquid crystal panel includes a TFT substrate and a color filter substrate that face each other with a liquid crystal layer interposed therebetween, and may display an image by using light provided from a backlight unit. In addition, an OLED panel may display an image by depositing an organic material layer capable of self-emitting light on a substrate on which a transparent electrode is formed.

Recently, much research has been done on a transparent display panel that may not only display images to a user, but also allow a user to see behind a display panel.

KR20170089113A relates to a display panel including a plurality of transparent areas and a plurality of light emitting areas alternately disposed, a back cover positioned on a rear surface of the display panel, and a shielding film disposed on at least one side of the cover, wherein the shielding film has a first state in which a transparent region of the display panel is exposed and a second state in which a transparent region of the display panel is shielded.

### [DETAILED DESCRIPTION OF INVENTION]

### [TECHNICAL PROBLEMS]

An object of the present disclosure is to solve the above-described problems and other problems.

Another object is to provide a display device including a transparent display panel.

Another object may be to provide a structure for opening or closing a rear of a transparent display panel.

Another object may be to provide a method for controlling an image output in a light-transmitting mode or a light-blocking mode of a transparent display panel.

### [TECHNICAL SOLUTION]

In accordance with an aspect of the present disclosure for achieving the above and other objectives, a display device is defined in appended claim 1 and includes: a display panel having a light emitting region and a transparent region; a plurality of plates positioned behind the display panel, extending in one direction, and sequentially arranged in the other direction; and a side frame extending along a periphery of the display panel, and to which each of the plurality of plates is rotatably coupled around a rotation axis parallel to the one direction, wherein the plurality of plates are sequentially rotated along the other direction, and open or close a rear of the display panel, wherein the plurality of plates include: a first plate; and a second plate spaced apart from the first plate in the other direction, wherein a rotation start point of the second plate is later than a rotation end point of the first plate.

### [EFFECT OF INVENTION]

The effects of the display device according to the present disclosure will be described as follows.

According to at least one of the embodiments of the present disclosure, a display device including a transparent display panel is provided.

According to at least one of the embodiments of the present disclosure, a structure for opening or closing a rear of a transparent display panel may be provided.

According to at least one of the embodiments of the present disclosure, a method for controlling an image output in a light-transmitting mode or a light-blocking mode of a transparent display panel may be provided.

Further scope of applicability of the present disclosure will become apparent from the following detailed description. However, it should be understood that the detailed description and specific embodiments such as preferred embodiments of the present disclosure are given by way of illustration only, since various changes and modifications within the scope of the present disclosure may be clearly understood by those skilled in the art.

### [BRIEF DESCRIPTION OF THE DRAWING]

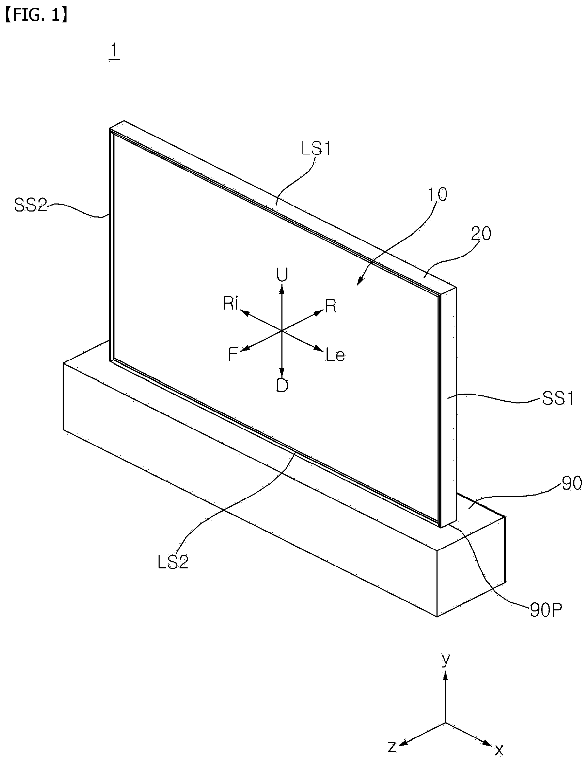

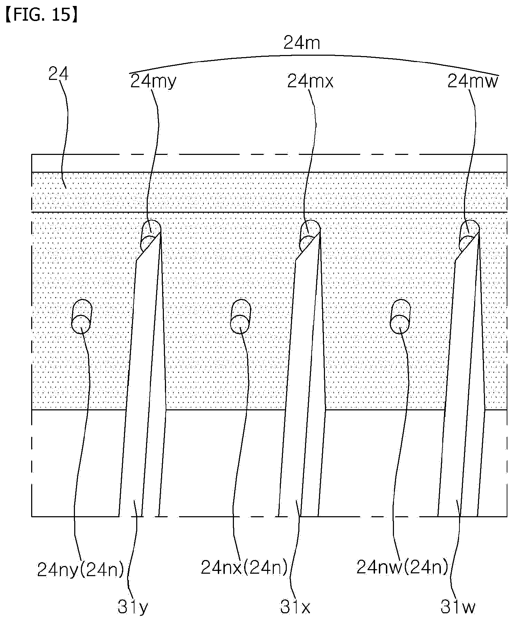

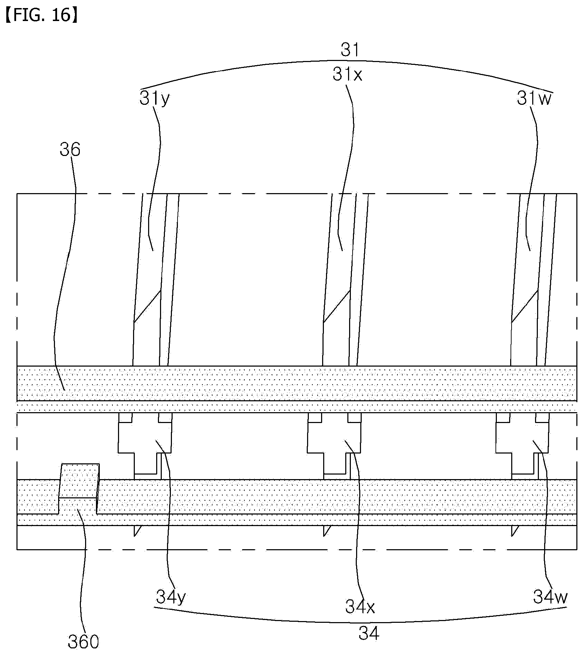

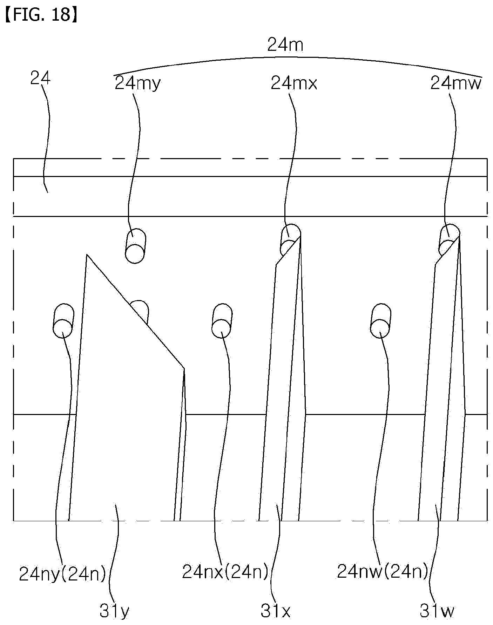

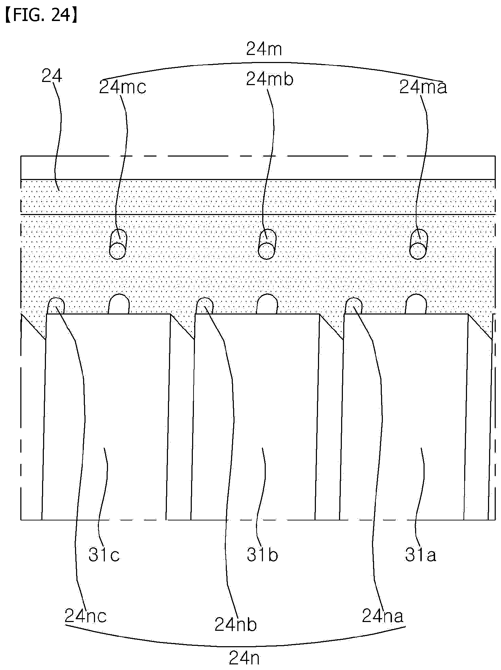

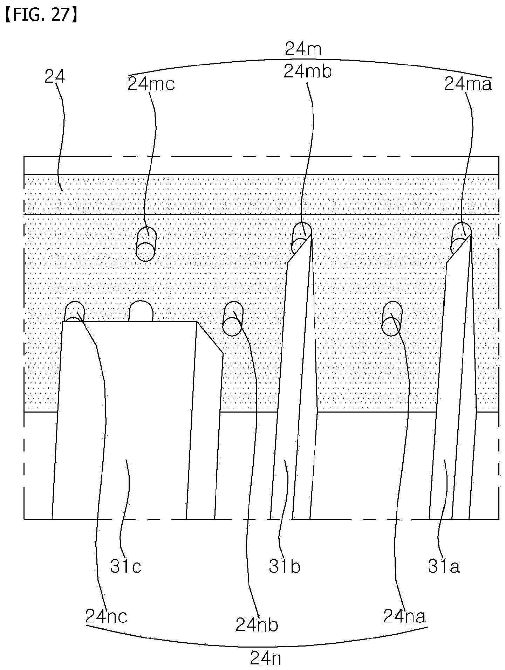

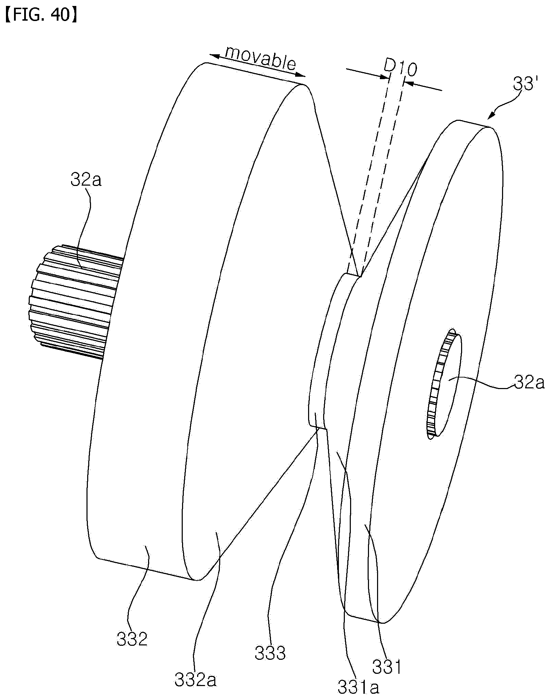

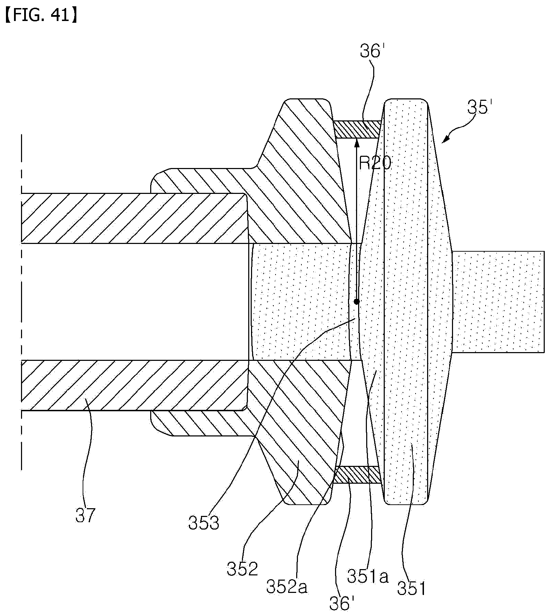

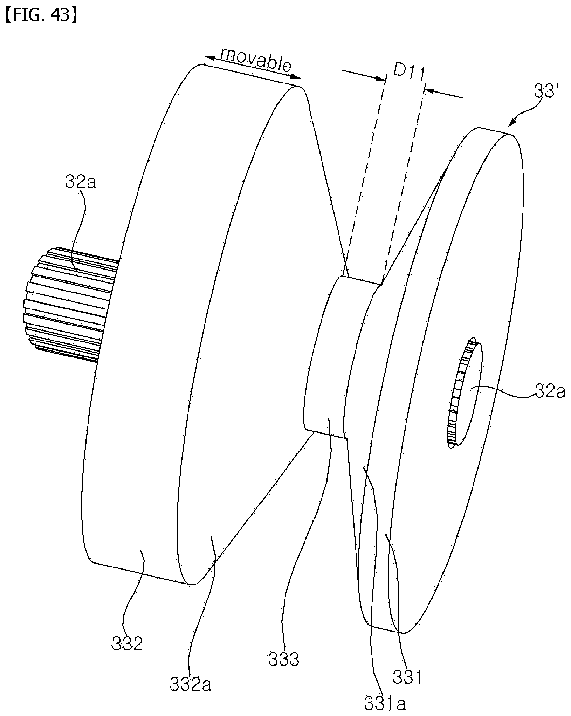

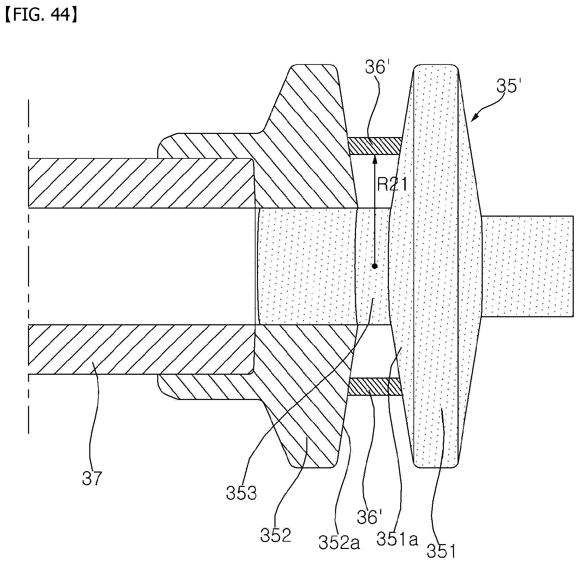

FIGS. 1 to 49 are diagrams illustrating examples of a display device according to embodiments of the present disclosure.

### [MODE FOR CARRYING OUT THE INVENTION]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

Direction indications of up (U), down (D), left (Le), right (Ri), front (F), and rear (R) shown in the drawings are only for convenience of explanation, and the technical concept disclosed in this specification is not limited thereto.

Referring to FIG. 1, a display device 1 may include a display 10, a side frame 20, and a housing 90. The display 10 may display an image. The side frame 20 may extend along a circumference of the display 10. The housing 90 may be located below the display 10 and the side frame 20.

The display device 1 may include a first long side LS1, a second long side LS2 opposite to the first long side LS1, a first short side SS1 adjacent to the first long side LS1 and the second long side LS2, and a second short side SS2 opposite to the first short side SS1.

Meanwhile, for the convenience of explanation, the lengths of the first and second long sides LS1 and LS2 are illustrated and described as being longer than the lengths of the first and second short sides SS1 and SS2, but it may also be possible that the lengths of the first and second long sides LS1 are LS2 are approximately the same as the lengths of the first and second short sides SS1 and SS2.

The long sides LS and LS2 and short sides SS1 and SS2 of the display device 1 may be formed on the side frame 20. The direction parallel to the long sides LS1 and LS2 of the display device 1 may be referred to as a left-right direction. The direction parallel to the short sides SS1 and SS2 of the display device 1 may be referred to as an up-down direction. The direction perpendicular to the long sides LS1 and LS2 and the short sides SS1 and SS2 of the display device 1 may be referred to as a front-rear direction.

The direction in which the display device 1 displays an image may be referred to as a front (F, z), and the opposite direction may be referred to as a rear R. The side of the first short side SS1 may be referred to as a left Le, x. The side of the second short side SS2 may be referred to as a right Ri. The side of the first long side LS1 may be referred to as an upper side U, y. The side of the second long side LS2 may be referred to as a lower side D.

Hereinafter, a display panel using an organic light emitting diode (OLED) will be described as an example, but the display panel applicable to the present disclosure is not limited thereto.

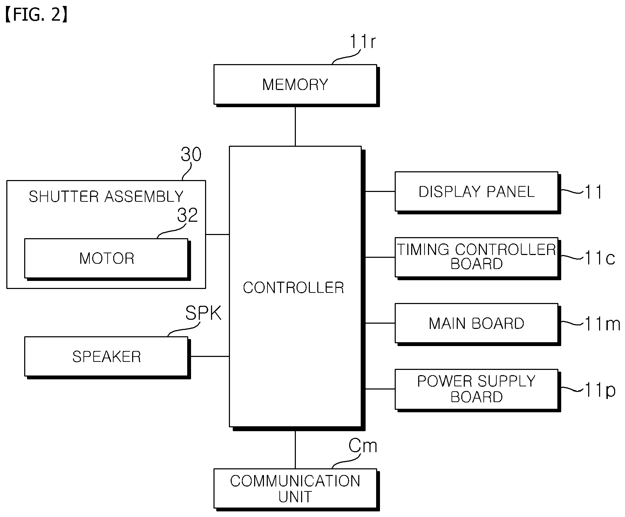

Referring to FIG. 2, a controller 110 of the display device 1 may control the operation of the display device 1. The controller 110 may be electrically connected to the components of the display device.

A display panel 11, a main board 11m, a power supply board 11p, and a timing controller board 11c may be installed in the internal space of the housing 90 and may be electrically connected to the controller 110. The main board 11m may control the display device 1. The controller 110 may be implemented as the main board 11m or may be a higher level controller that controls the main board 11m, etc. The power supply board 11p may provide power to each component of the display device 1. The timing controller board 11c may provide an image signal to the display panel 11.

A motor 32 and a sensor 39b of a blind assembly 30 may be electrically connected to the controller 110. The controller 110 may control the operation of the motor 32, i.e., the amount of rotation (rotation angle), the direction of rotation, and the rotation speed. Such a motor 32 may be a step motor. The controller 110 may detect the operation of the motor 32 based on information obtained from the sensor 39b.

The speaker (SPK) may be installed in the internal space of the housing 90, and may be electrically connected to the controller 110. A speaker hole (not shown) may be formed in the housing 90, and the speaker (SPK) may provide sound through the speaker hole.

A communication unit Cm may transmit information of the display device 1 to an external device, or transmit various information or signals from an external device to the display device 1. The communication unit Cm may perform communication with a remote control device, a portable terminal, a wired/wireless router, or other communication infrastructure (e.g., a server). For example, the communication unit Cm may perform wireless communication with an external device by using communication technologies such as IEEE 802.11 WLAN, IEEE 802.15 WPAN, UWB, Wi-Fi, Zigbee, Z-wave, and Blue-Tooth.

A memory 11r may be electrically connected to the controller 110. The memory 11r may store basic data for the display device 1 (e.g., basic specification information for each configuration of the display device, such as display resolution, brightness, sound output value, and the number and location of plates of blind assembly), data and programs for controlling the operation of the display device 1, data input from the outside, or data processed by the controller 110, etc. For example, the memory 11r may store information related to the operation of the motor 32. For example, the memory 11r may include ROM, RAM, EPROM, a flash drive, a hard drive, or the like. For example, the memory 11r may be classified as a sub-configuration of the controller 110.

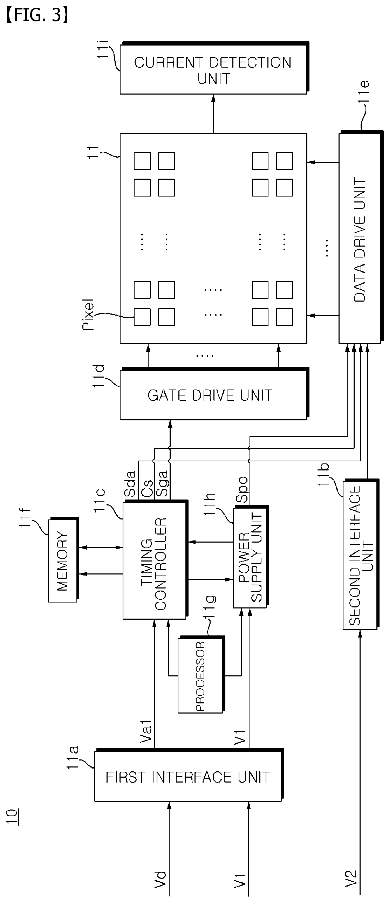

Referring to FIG. 3, the display 10 may include a display panel 11, a first interface unit 11a, a second interface unit 11b, a timing controller 11c, a gate drive unit 11d, a data drive unit 11e, a memory 11f, a processor 11g, a power supply unit 11h, and a current detection unit 11i. The display panel 11 may be an Organic Light Emitting Diode (OLED) panel.

The first interface unit 11a may receive a first DC power V1 from a power supply unit external to the display 10, and the first DC power V1 may be provided for the operation of the power supply unit 11h and the timing controller 11c.

The second interface unit 11b may receive a second DC power V2 from a power supply unit external to the display 10, and the second DC power V2 may be provided to the data drive unit 11e.

The timing controller 11c may output a data drive signal Sda and a gate drive signal Sga, based on the image signal Vd input to the first interface unit 11a. For example, the first interface unit 11a may convert the image signal Vd and output a converted + image signal Va1, and the timing controller 11c may output a data drive signal Sda and a gate drive signal Sga, based on the converted image signal Vd. Such a data drive signal Sda may be a signal for driving subpixels of the display panel 11. In addition, the timing controller 11c may further output a control signal Cs to the gate drive unit 11d.

The gate drive unit 11d and the data drive unit 11e may provide a scanning signal and an image signal to the display panel 11 through a gate line GL and a data line DL, according to the gate drive signal Sga and the data drive signal Sda of the timing controller 11c. Accordingly, the display panel 11 may display an image.

The power supply unit 11h may provide various powers to the gate drive unit 11d, the data drive unit 11e, and the timing controller 11c.

The current detection unit 11i may detect the current flowing in the subpixel of the display panel 11. The detected current may be input to the processor 11g for calculation of cumulative current. The calculated cumulative current may be stored in the memory 11f.

The processor 11g may perform various controls within the display 10. For example, the processor 11g may control the gate drive unit 11d, the data drive unit 11e, and the timing controller 11c.

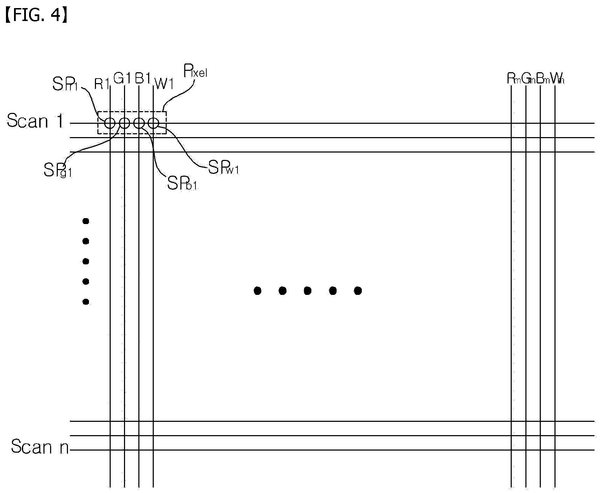

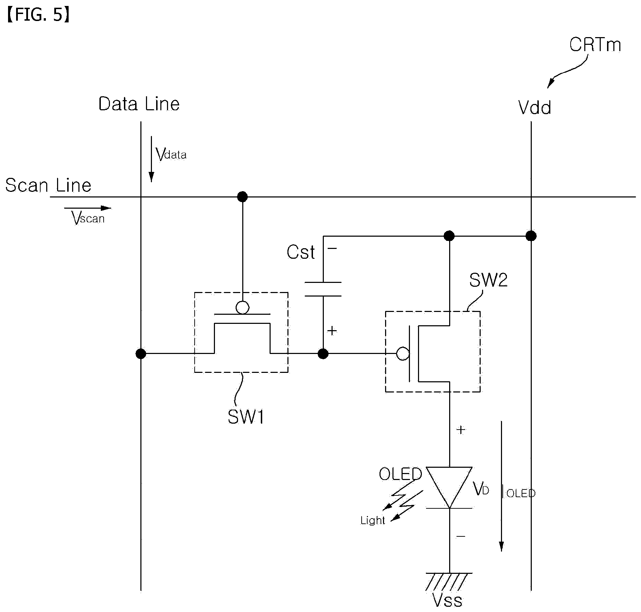

Referring to FIGS. 4 and 5, the display panel 11 may include a plurality of scan lines (Scan 1 to Scan n) and a plurality of data lines (R1, G1, B1, W1 to Rm, Gm, Bm, Wm). The plurality of data lines (R1, G1, B1, W1 to Rm, Gm, Bm, Wm) may intersect with the plurality of scan lines (Scan 1 to Scan n). A subpixel may be defined in an intersection area of the scan line and the data line. A pixel may be a hold type element that continues to emit light in an organic light-emitting layer (OLED) during a unit frame image after a scan signal is applied. For example, a pixel may have RGBW subpixels. For another example, a pixel may have RGB subpixels.

The circuit CRTm of the subpixel may be an active type, and may include a scan switching element SW1, a storage capacitor Cst, a drive switching element SW2, and an organic light-emitting layer (OLED).

The scan switching element SW1 may be turned on according to a scan signal Vscan input from the scan line. When the scan switching element SW1 is turned on, the scan switching element SW1 may transmit a data signal Vdata input from the data line to one end of the storage capacitor Cst or the gate terminal of the drive switching element SW2.

A storage capacitor Cst may be provided between the gate terminal and the source terminal of the drive switching element SW2, and may store the difference between the data signal level transmitted to one end of the storage capacitor Cst and the DC power VDD level transmitted to the other end of the storage capacitor Cst.

For example, if the data signal has a different level according to a Pulse Amplitude Modulation (PAM) method, the power level stored in the storage capacitor Cst may vary depending on the level difference of the data signal Vdata. For another example, if the data signal has a different pulse width according to a Pulse Width Modulation (PWM) method, the power level stored in the storage capacitor Cst may vary depending on the pulse width difference of the data signal Vdata.

The drive switching element SW2 may be turned on depending on the power level stored in the storage capacitor Cst. When the drive switching element SW2 is turned on, a drive current (IOLED) proportional to the stored power level may flow to the organic light-emitting layer (OLED). Accordingly, the organic light-emitting layer (OLED) may perform a light-emitting operation.

The organic light-emitting layer (OLED) may have an RGBW emitting layer (EML) corresponding to the subpixel, may include at least one of a hole injection layer HIL, a hole transport layer HTL, an electron transport layer ETL, or an electron injection layer EIL, and may also include a hole blocking layer HBL.

Meanwhile, FIG. 5 illustrates a p-type MOSFET as a scan switching element SW1 and a drive switching element SW2, but a switching element such as an n-type MOSFET, JFET, IGBT, and SIC may be used.

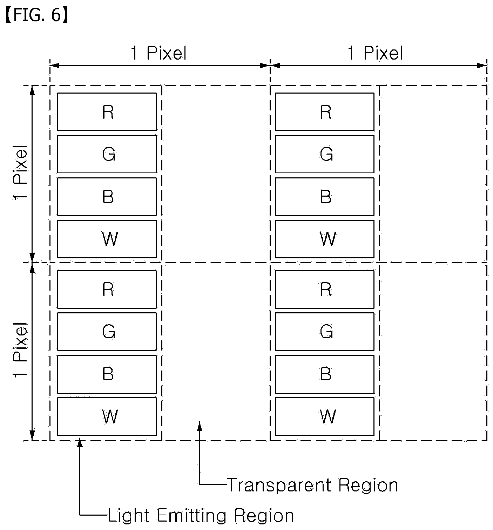

Referring to FIG. 6, a pixel may include a light emitting region and a transparent region. In the light emitting region, RGBW subpixels may be arranged in a longitudinal direction, and the transparent region without subpixels may be arranged next to the light emitting region.

Accordingly, the display panel 11 having a plurality of pixels may not only display an image but also transmit light. The display panel 11 may be referred to as a transparent display panel or a transparent OLED panel.

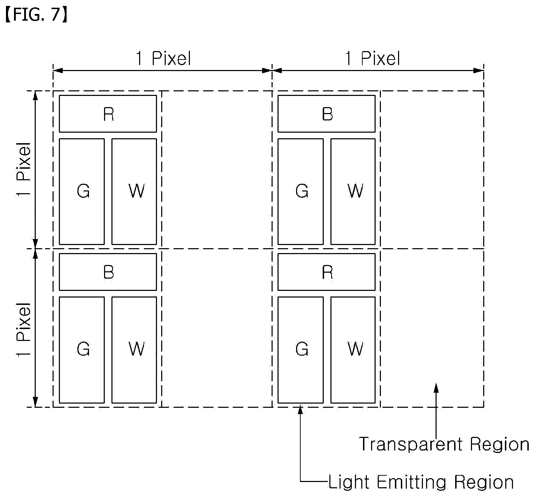

Referring to FIG. 7, a pixel may include a light emitting region and a transparent region. In the light emitting region, subpixels of RGW or BGW may be arranged adjacent to each other, and the transparent region having no subpixel may be arranged next to the light emitting region.

Accordingly, the display panel 11 having a plurality of pixels may not only display an image but also transmit light. The display panel 11 may be referred to as a transparent display panel or a transparent OLED panel.

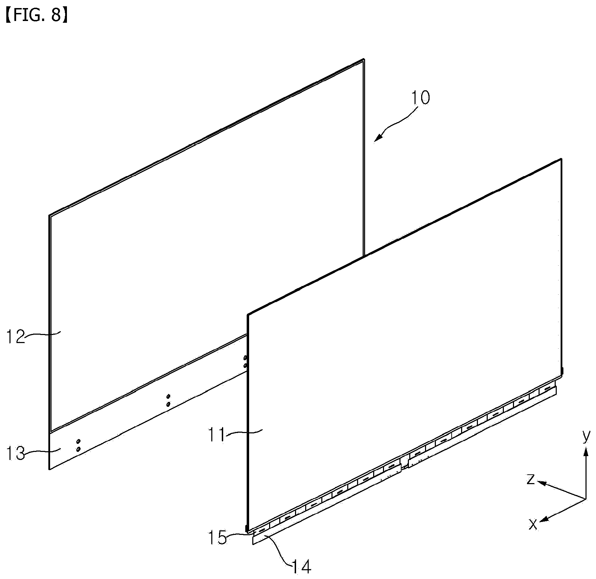

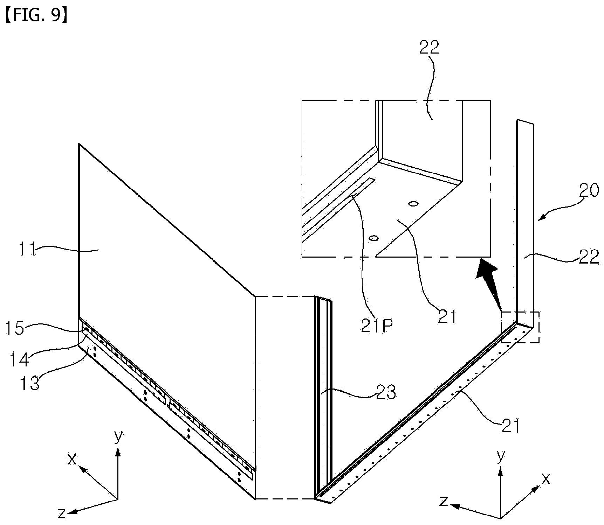

Referring to FIGS. 8 and 9, the display panel 11 may output an image by dividing an image into a plurality of pixels and adjusting the color, brightness, and saturation for each pixel. The display panel 11 may be divided into an active area where an image is displayed and a de-active area where an image is not displayed. The display panel 11 may generate light corresponding to the color of red R, green G, or blue B according to a control signal.

A source PCB 14 may be adjacent to the lower side of the display panel 11 and may extend along the lower side. The source PCB 14 may be electrically connected to the display panel 11 through a source Chip On Film (COF) 15. The source PCB 14 may be electrically connected to the timing controller board 11c (see FIGS. 1 and 2) through a cable (not shown) such as a Flexible Flat Cable (FFC).

The transparent panel 13 may be located in front of the display panel 11. The transparent panel 13 may be glass of a transparent material. An adhesive film 12 may be located between the display panel 11 and the transparent panel 13, and may be coupled to the display panel 11 and the transparent panel 13. The adhesive film 12 may be an Optically Clear Adhesive (OCA) film.

For example, the size of the adhesive film 12 may correspond to the size of the display panel 11, and may be smaller than the size of the transparent panel 13.

Meanwhile, the display panel 11, the adhesive film 12, and the transparent panel 13 may be collectively referred to as the display 10.

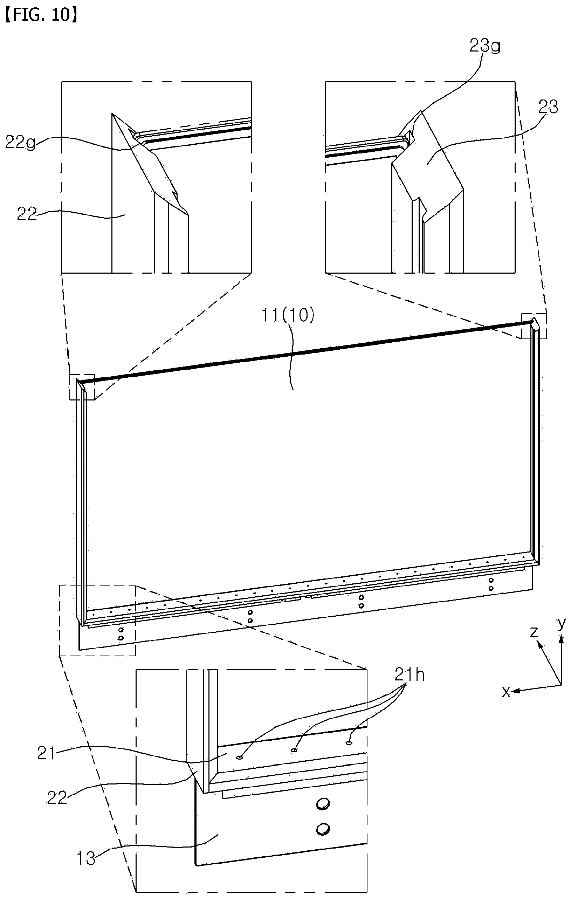

Referring to FIGS. 9 and 10, a bottom part 21 of the side frame 20 may be adjacent to the lower side of the display 10, and may extend along the lower side. A slit 21P may be formed by penetrating the bottom part 21 in the vertical direction, and may extend in the longitudinal direction of the bottom part 21. The transparent panel 13 may penetrate the slit 21P, and the display panel 11 may be located above the bottom part 21.

A left part 22 of the side frame 20 may be adjacent to the left side of the display 10, and may extend along the left side. The lower end of the left part 22 may be coupled to the left distal end of the bottom part 21. The left groove 22g may be formed in the inner side of the left part 22, and may extend in the longitudinal direction of the left part 22. The left groove 22g may be located closer to the front end than the rear end of the left part 22. The left side of the display 10 may be inserted into the left groove 22g.

A right part 23 of the side frame 20 may be adjacent to the right side of the display 10, and may extend along the right side. The lower end of the right part 23 may be coupled to the right distal end of the bottom part 21. The right groove 23g may be formed in the inside of the right part 23, and may extend in the longitudinal direction of the right part 23. The right groove 23g may be located closer to the front end than the rear end of the right part 23. The right side of the display 10 may be inserted into the right groove 23g.

A bottom hole 21h may be formed by penetrating the bottom part 21 in the vertical direction. The bottom hole 21h may be spaced in a rearward direction from the display panel 11. A plurality of bottom holes 21h may be spaced apart from each other in the longitudinal direction of the bottom part 21.

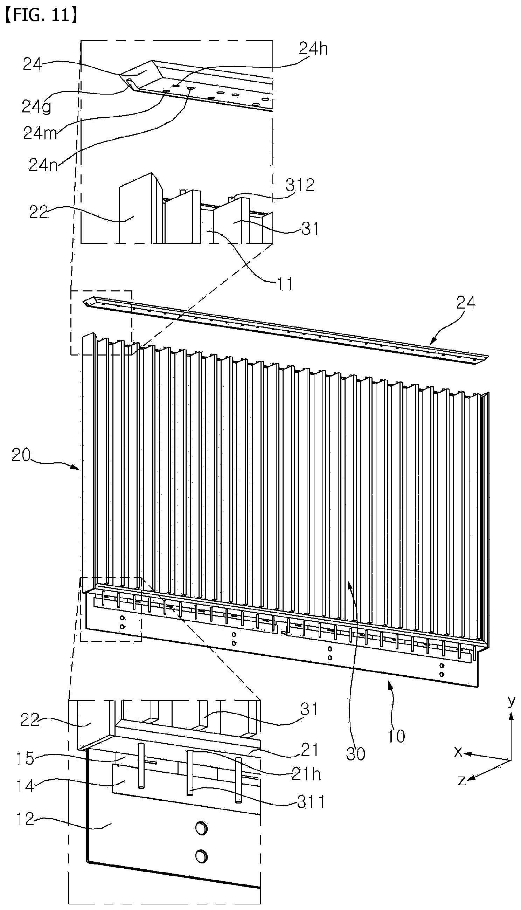

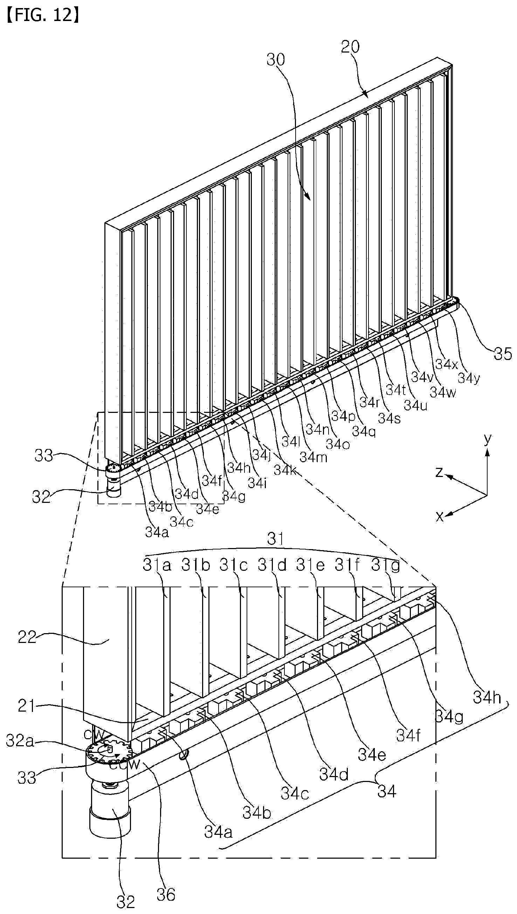

Referring to FIGS. 11 and 12, a top part 24 of the side frame 20 may be adjacent to the upper side of the display 10, and may extend along the upper side. The left distal end of the top part 24 may be coupled to the upper end of the left part 22, and the right distal end of the top part 24 may be coupled to the upper end of the right part 23. The top groove 24g may be formed in the inner side of the top part 24, and may extend in the longitudinal direction of the top part 24. The top groove 24g may be located closer to the front end than the rear end of the top part 24. The upper side of the display 10 may be inserted into the top groove 24g. Accordingly, the side frame 20 may have a rectangular frame shape, and may cover the circumference of the display panel 11.

A top hole 24h may be a groove formed on the inside of the top part 24, or may be formed by penetrating the top part 24 in the up-down direction. In the vertical direction, the top hole 24h may be aligned with the bottom hole 21h (see FIG. 10). A plurality of top holes 24h may be spaced apart from each other in the longitudinal direction of the top part 24.

The blind assembly 30 may include a plate 31, a motor 32, a drive pulley 33, a wheel 34, a driven pulley 35, and a belt 36. Here, the motor 32, the drive pulley 33, the wheel 34, the driven pulley 35, and the belt 36 may be collectively referred to as a drive module.

The plate 31 may be located at the rear of the display panel 11, and may be located at the inside of the side frame 20. The plate 31 may be extended vertically. The plate 31 may be referred to as a blind 31 or a blade 31.

The lower end of the plate 31 may be located on or adjacent to the upper surface of the bottom part 21. A bottom pin 31B of the plate 31 may protrude downward from the lower end of the plate 31, may penetrate the bottom hole 21h (see FIG. 10) of the bottom part 21, and may be rotatably coupled to the bottom part 21.

The upper end of the plate 31 may be located on or adjacent to the lower surface of the top part 24. A top pin 31T of the plate 31 may protrude upward from the upper end of the plate 31, may penetrate the top hole 24h of the top part 24, and may be rotatably coupled to the top part 24.

The bottom pin 311 and the top pin 312 may be aligned with each other in the longitudinal direction of the plate 31, i.e., the vertical direction. The rotation axis of the plate 31 may be coaxial with the central axes of the bottom pin 311 and the top pin 312.

A plurality of plates 31 may be sequentially arranged from the left part 22 toward the right part 23 and may be adjacent to each other. Each of the plurality of plates 31 may be rotatably coupled to the bottom part 21 and the top part 24. Among the plurality of plates 31, the rotation axis of any one plate may be parallel to the rotation axis of the other plate.

The motor 32 may be located below the bottom part 21. The motor 32 may be adjacent to the left part 22 or the right part 23. The motor 32 may provide rotational power. The motor 32 may be an electric motor capable of adjusting the rotational direction, rotational angle, and rotational speed, and may have a rotation axis 32a that is parallel to the vertical direction.

The drive pulley 33 may be orthogonal to the rotation axis 32a of the motor 32, and may be fixed to the rotation axis 32a. For example, the drive pulley 33 may be located below the left part 22, and the motor 32 may be opposite to the left part 22 with respect to the drive pulley 33. In this case, the driven pulley 35 may be located below the right part 23. The belt 36 may be engaged with the drive pulley 33 and the driven pulley 35. The belt 36 may be a timing belt.

The wheel 34 may be located between the drive pulley 33 and the driven pulley 35, and may be adjacent to the inner surface of the belt 36. The wheel 34 may be opposite to the plate 31 with respect to the bottom part 21, and may be fixed to the bottom pin 311 of the plate 31. The bottom pin 311 of each of the plurality of plates 31 may be fixed to each of the plurality of wheels 34, and may provide a rotation axis of each of the plurality of wheels 34. For example, the wheel 34 may be formed as one body with the distal end of the bottom pin 311. Accordingly, the wheel 34 and the plate 31 may be rotated together.

In addition, the wheel 34 may be a cross-shaped wheel, a T-shaped wheel, or an L-shaped wheel.

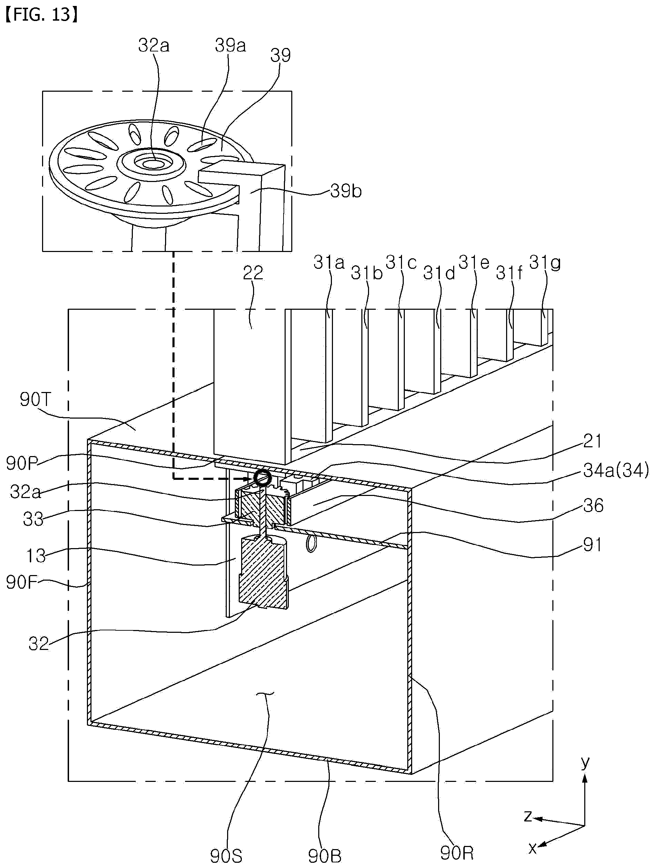

Referring to FIG. 13, the aforementioned motor 32, drive pulley 33, wheel 34, driven pulley 35, and belt 36 may be accommodated in an internal space 90S of the housing 90.

An opening 90P may be formed in the top part 90T of the housing 90, and a part of the bottom part 21 may penetrate therethrough. A mount plate 91 may protrude horizontally from the inside of a rear part 90R of the housing 90, and may be located closer to the top part 90T than to the bottom part 90B of the housing 90. The motor 32 may be mounted on the lower surface of the mount plate 91, and the drive pulley 33, the wheel 34, the driven pulley 35, and the belt 36 may be located higher than the mount plate 91.

A disc indicator 39 may be adjacent to the distal end of the rotation axis 32a of the motor 32, and may be fixed to the rotation axis 32a. A plurality of holes 39a may be formed in the disc indicator 39, and may be spaced apart from each other in the circumferential direction of the disc indicator 39.

The sensor 39b may be adjacent to the disc indicator 39 and may be fixed to the mount plate 91. The sensor 39b may be a photo sensor and may have a horseshoe shape. A light emitting portion and a light receiving portion of the sensor 39b may be opposite to each other with respect to the disc indicator 39. That is, the disc indicator 39 may rotate while passing through a space between the light emitting portion and the light receiving portion according to the rotation of the rotation axis 132a, and the light of the light emitting portion may pass through the hole 39a or be blocked by the disc indicator 39. Accordingly, the sensor 39b may detect the number of revolutions and/or the amount of rotation of the motor 132.

Referring again to FIG. 11, a first magnet 24m and a second magnet 24n may be formed around the top hole 24h. Alternatively, the first magnet 24m and the second magnet 24n may be formed around the bottom hole 21h (see FIG. 10), or may be formed around each of the top hole 24h and the bottom hole 21h.

The first magnet 24m may be located between the top hole 24h and the display panel 11. The second magnet 24n may be spaced apart from the first magnet 24m by 90 degrees with respect to the top hole 24h. Such first magnet 24m and second magnet 24n may form a single group, and each group may be formed around each of the plurality of top holes 24h.

The plate 31 may include a magnetic substance such as iron Fe. A magnetic attraction may be applied between the plate 31 and the magnet 24m, 24n.

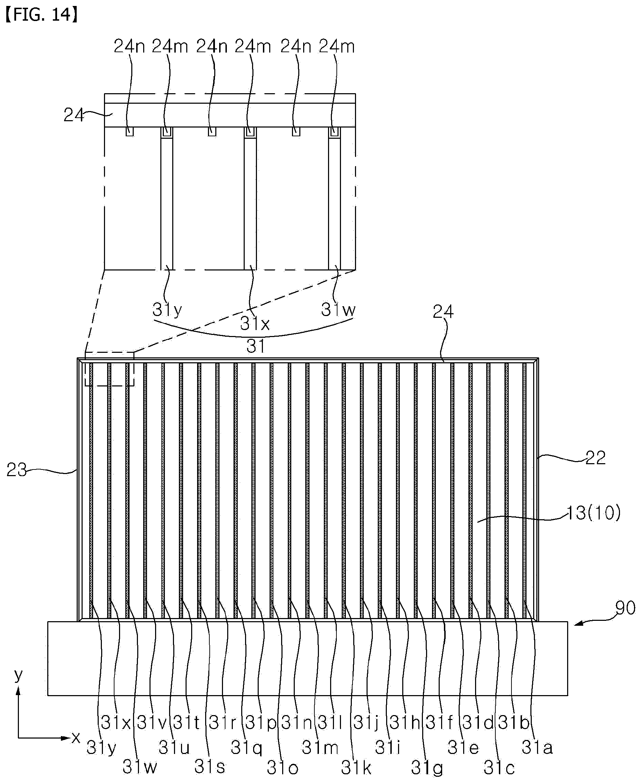

Referring to FIGS. 14 to 16, a protrusion 360 may be formed on the inner surface of the belt 36. The protrusion 360 may protrude further inwardly of the belt 36 than a portion (i.e., the inner circumferential surface of the belt 36) of the belt 36 that engages the drive pulley 33. The plurality of wheels 34 may be spaced apart from the inner surface of the belt 36. The plurality of wheels 34 may be located in front of the protrusion 360, and located on the movement path of the protrusion 360 corresponding to the movement of the belt 36.

A first plate 31a, a second plate 31b, a third plate 31c, a fourth plate 31d, a fifth plate 31e, a sixth plate 31f, a seventh plate 31g, an eighth plate 31h, a ninth plate 31i, a tenth plate 31j, an eleventh plate 31k, a twelfth plate 31l, a thirteenth plate 31m, a fourteenth plate 31n, a fifteenth plate 31o, a sixteenth plate 31p, a seventeenth plate 31q, an eighteenth plate 31r, a nineteenth plate 31s, a twentieth plate 31t, a twenty-first plate 31u, a twenty-second plate 31v, a twenty-third plate 31w, a twenty-fourth plate 31x, and a twenty-fifth plate 31y may be arranged sequentially from the left part 22 to the right part 23.

A plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may be arranged parallel to each other. The thickness direction of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may be parallel to the left-right direction. A space may be formed between the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y. The angle of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may be 0 degree. At this time, the protrusion 360 may be located between a twenty-fifth wheel 34y fixed to the twenty-fifth plate 31y and the driven pulley 35 (see FIG. 11).

The twenty-fifth plate 31y may be closest to the right part 23, and the upper side of the twenty-fifth plate 31y may face the first magnet 24my and be magnetically coupled thereto. The twenty-fourth plate 31x may be opposite to the right part 23 with respect to the twenty-fifth plate 31y, and the upper side of the twenty-fourth plate 31x may face the first magnet 24mx and be magnetically coupled thereto. The twenty-third plate 31w may be opposite to the twenty-fifth plate 31y with respect to the twenty-fourth plate 31x, and the upper side of the twenty-third plate 31w may face the first magnet 24mw and be magnetically coupled thereto.

Likewise, the first to twenty-second plates 31a, 31b, 31c, 31d, 31e, 31f, 31g, 31h, 31i, 31j, 31k, 31l, 31m, 31n, 31o, 31p, 31q, 31r, 31s, 31t, 31u, and 31v may be magnetically coupled to the first magnet 24m (see FIG. 11). Accordingly, the plurality of first magnets 24m may fix the location of the plurality of plates 31.

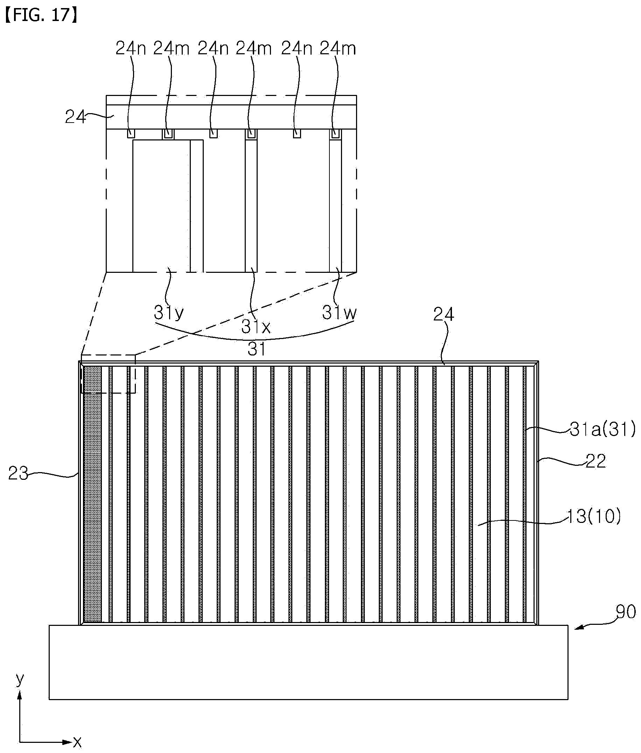

Referring to FIGS. 17 to 19, the wheel 34 may be a cross-shaped wheel. Alternatively, the wheel 34 may be a T-shaped wheel or an L-shaped wheel.

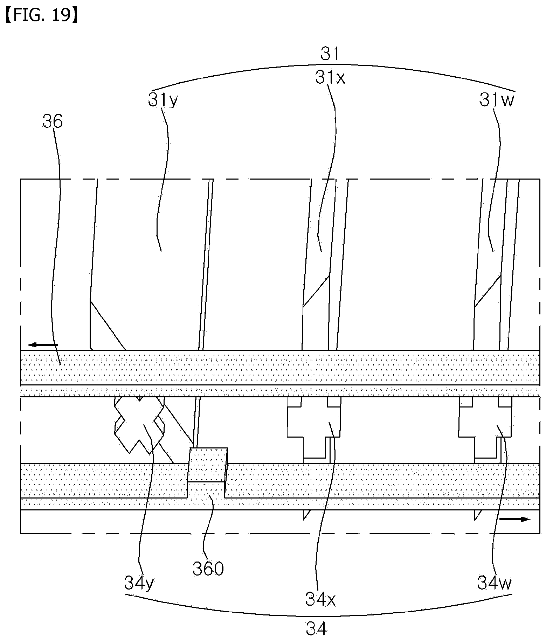

When the drive pulley 33 rotates clockwise CW (see FIG. 12), according to the movement of the belt 36 (see the arrow in FIG. 19), the protrusion 360 may hit the twenty-fifth wheel 34y fixed to the twenty-fifth plate 31y and rotate the twenty-fifth wheel 34y, and may approach the twenty-fourth wheel 24x fixed to the twenty-fourth plate 31x. At this time, the twenty-fifth plate 31y may be rotated by 45 degrees or more by the protrusion 360, and may be further rotated by being attracted by the magnetic force of the second magnet 24ny. As a result, the twenty-fifth plate 31y may be rotated from 0 degree to 90 degrees.

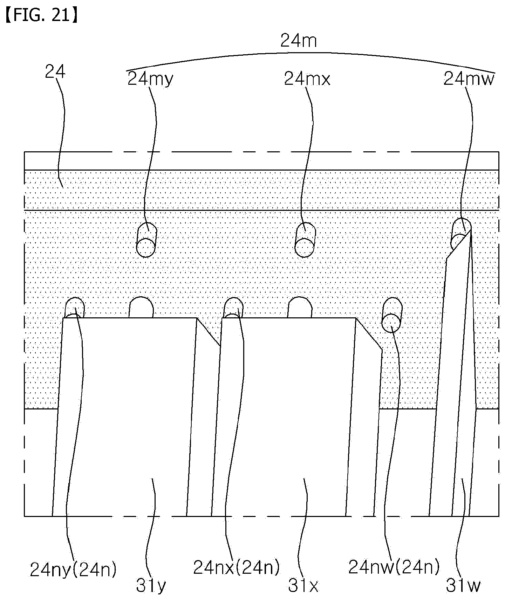

Accordingly, the upper surface of the twenty-fifth plate 31y may face the second magnet 24ny and be magnetically coupled thereto (see FIG. 21). In addition, the second magnet 24ny may fix the location of the twenty-fifth plate 31y.

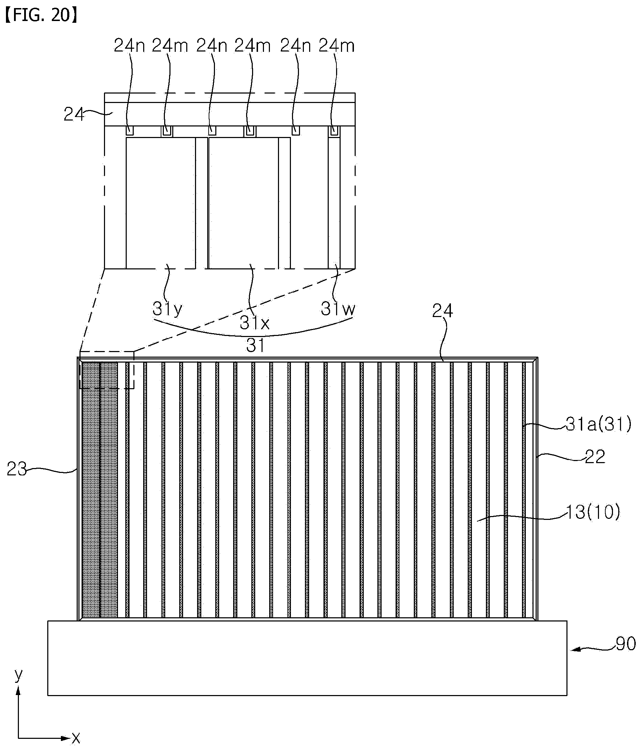

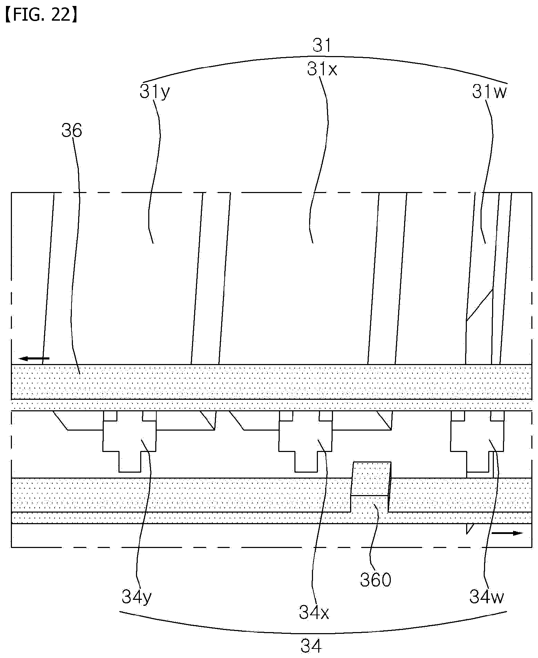

Referring to FIGS. 20 to 22, if the drive pulley 33 continues to rotate clockwise CW (see FIG. 12), the protrusion 360 may be located between the twenty-fourth wheel 34x fixed to the twenty-fourth plate 31x and the twenty-third wheel 34w fixed to the twenty-third plate 31w, according to the movement of the belt 36 (see the arrow in FIG. 22). That is, the protrusion 360 may rotate the twenty-fifth wheel 34y and the twenty-fourth wheel 34x, and as a result, the twenty-fifth plate 31y and the twenty-fourth plate 31x may be rotated from 0 degree to 90 degrees.

Accordingly, the upper side of the twenty-fifth plate 31y may face the second magnet 24ny and be magnetically coupled thereto, and the upper side of the twenty-fourth plate 31x may face the second magnet 24nx and be magnetically coupled thereto. In addition, the second magnet 24ny, 24nx may fix the location of the twenty-fifth plate 31y and the twenty-fourth plate 31x.

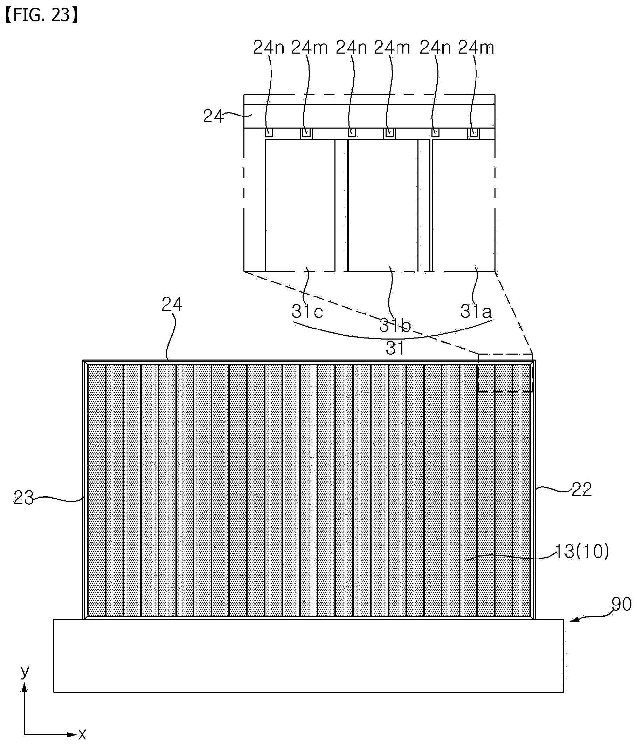

Referring to FIGS. 23 to 25, when the drive pulley 33 continues to rotate clockwise CW (see FIG. 12), the protrusion 360 may be located between the first wheel 34a fixed to the first plate 31a and the drive pulley 33 (see FIG. 12), according to the movement of the belt 36 (see the arrow in FIG. 22). That is, the protrusion 360 may have rotated the wheels of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y, and as a result, the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may be rotated from 0 to 90 degrees.

Accordingly, the upper side of all plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may face the second magnet 24n and be magnetically coupled thereto. In addition, the second magnet 24n may fix the location of all plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y.

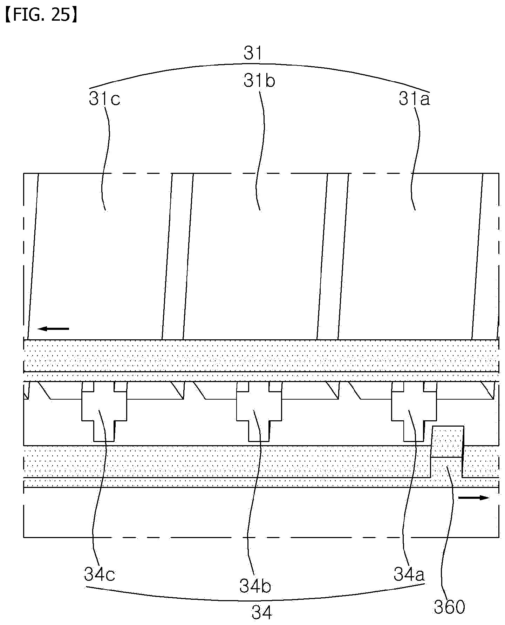

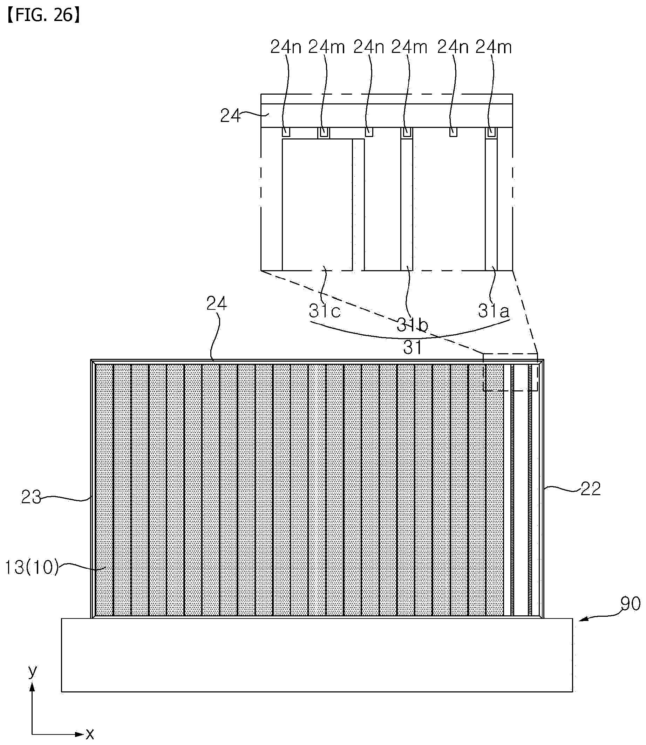

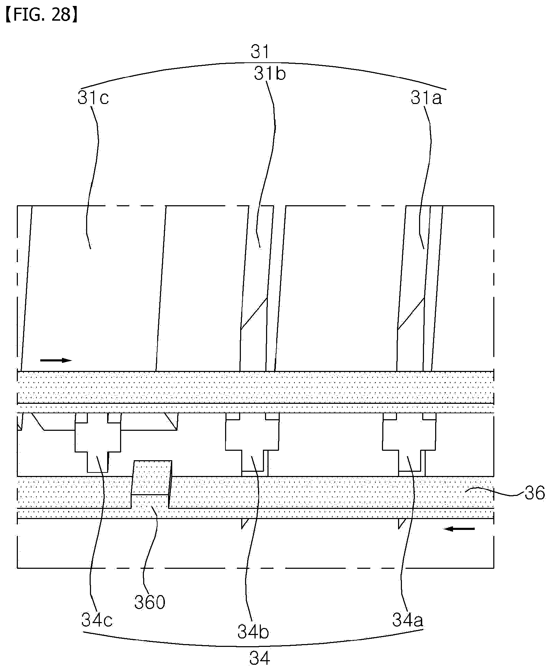

Referring to FIGS. 26 to 28, when the drive pulley 33 rotates counterclockwise CCW (see FIG. 12) from the state of FIG. 25, the protrusion 360 may be located between the second wheel 34b fixed to the second plate 31b and the third wheel 34c fixed to the third plate 31c, according to the movement of the belt 36 (see the arrow of FIG. 28). That is, the protrusion 360 may rotate the first wheel 34a fixed to the first plate 31a and the second wheel 34b fixed to the second plate 31b. At this time, the first plate 31a and the second plate 31b may be rotated 45 degrees or more by the protrusion 360, and may be further rotated by being attracted by the magnetic force of the first magnet 24ma, 24mb. As a result, the first plate 31a and the second plate 31b may be rotated from 90 degrees to 0 degree.

As described above, the upper side of the first plate 31a may face the first magnet 24ma and may be magnetically coupled thereto, and the upper side of the second plate 31b may face the second magnet 24mb and may be magnetically coupled thereto. In addition, the first magnet 24ma, 24mb may fix the location of the first plate 31a and the second plate 31b.

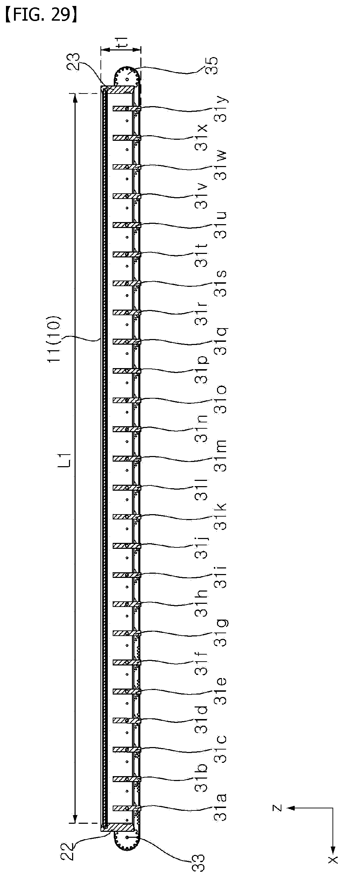

Referring to FIG. 29, the sum of the widths of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y may be substantially equal to the distance L1 between the left part 22 and the right part 23.

That is, when the angle of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y is 0 degree (see FIG. 14), the rear of the display 10 may be opened to the rear through a space between the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y.

In addition, when the angle of the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y is 90 degrees (see FIG. 23), the rear of the display 10 may be covered by the plurality of plates 31a, 31b, 31c, 31d, 31e, 31f, 31g, 31h, 31i, 31j, 31k, 31l, 31m, 31n, 31o, 31p, 31q, 31r, 31s, 31t, 31u, 31v, 31w, 31x, and 31y.

Meanwhile, considering the function of the plates that open and close the rear of the display panel 11, the width of the plates may increase as the number of plates provided in the display device decreases. In other words, as the number of plates provided in the display device increases, the width of the plates may decrease, and the overall thickness t1 of the display device may decrease.

Meanwhile, as the thickness of plates becomes thinner, the plates opening the rear of the display panel 11 may be less visible to a user in front of the display 10.

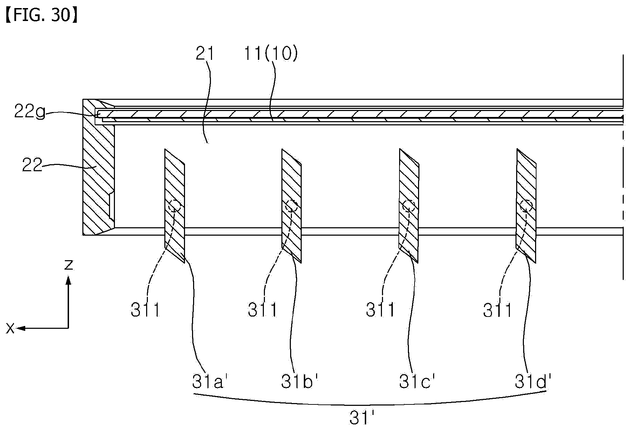

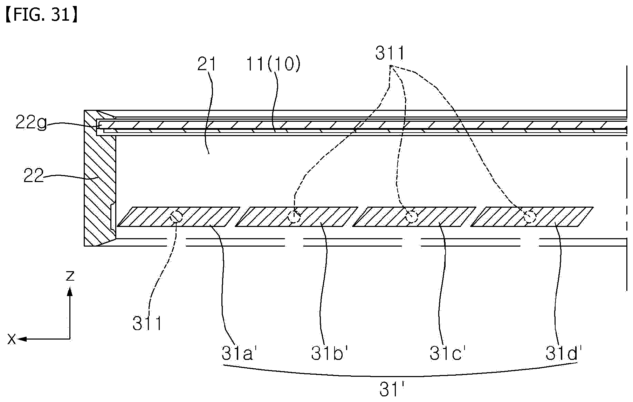

Referring to FIGS. 30 and 31, the plate 31 may have a cross section of a parallelogram. If the angle of the plates 31 is 90 degrees (see FIG. 23), among the adjacent plates 31, a part of any one may overlap with a part of another in the front-rear direction.

Accordingly, if the angle of the plates 31 is 90, a user in front of the display 10 may not recognize a gap between the plates 31.

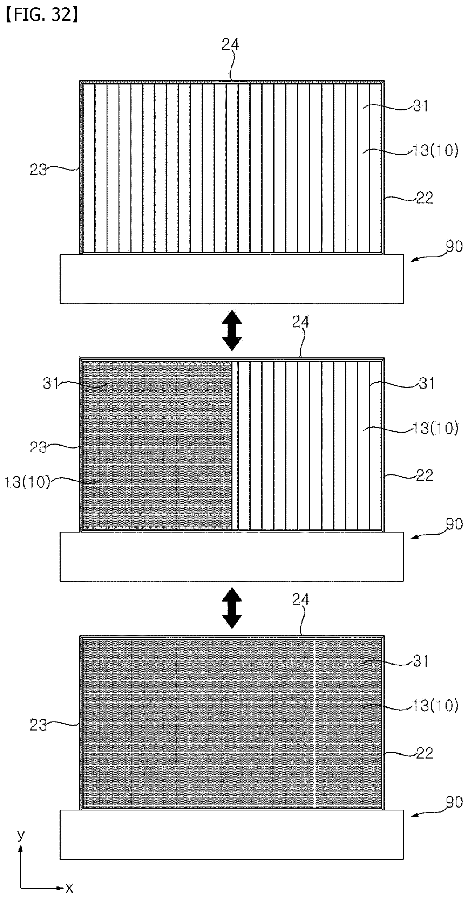

Referring to FIG. 32 from top to bottom, as the drive pulley 33 rotates clockwise CW (see FIG. 12), the plurality of plates 31 may be gradually rotated from 0 degree to 90 degrees in the direction from the right part 23 toward the left part 22. In addition, the rear of the display panel 11 may also be gradually closed in the direction from the right part 23 toward the left part 22.

Referring to FIG. 32 from the bottom to the top, as the drive pulley 33 rotates counterclockwise CCW (see FIG. 12), the plurality of plates 31 may be gradually rotated from 90 degrees to 0 degree in a direction from the left part 22 toward the right part 23. In addition, the rear of the display panel 11 may also be gradually opened in a direction from the left part 22 toward the right part 23.

That is, the rotation end point of the plate that rotates first among the plates 31 may be earlier than the rotation start point of the plate that rotates later.

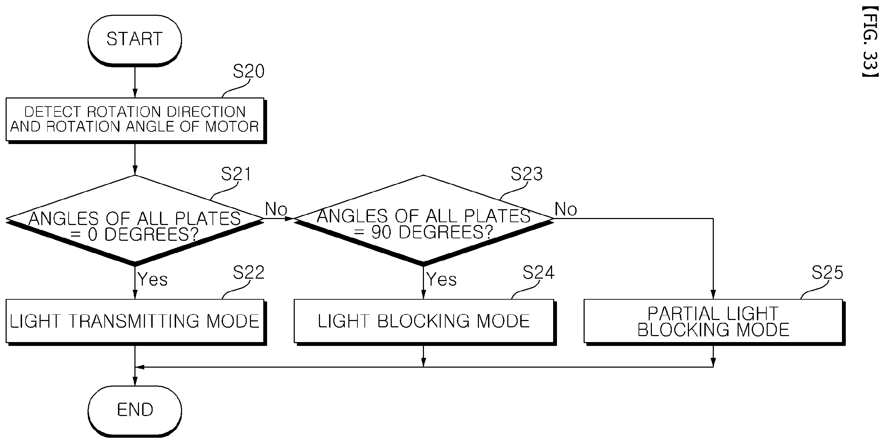

Referring to FIGS. 32 and 33, the controller 110 (see FIG. 2) of the display device may be electrically connected to the aforementioned motor 32 (see FIG. 13) and sensor 39b (see FIG. 13). The controller 110 may detect the rotation direction and rotation angle of the motor 32 based on information obtained from the motor 32 and the sensor 39b (S20). Here, the rotation direction and rotation angle of the motor 32 are the same as the rotation direction and rotation angle of the aforementioned drive pulley 33 (see FIG. 12).

After S20, the controller 110 may determine whether the angle of all the plates 31 is 0 degree S21. Here, if the angle of all the plates 31 is 0 degree, the rear of the display 10 is opened to the rear through a space between the plates 31.

If it is determined at S21 that the angle of all the plates 31 is 0 degree (S21: Yes), the controller 110 may determine that the mode of the display 10 is a light-transmitting mode (S22) (see the upper drawing of FIG. 32). For example, the display 10 may not display an image, and a user in front of the display 10 may see the rear of the display 10 through the plates 31. In another example, the display 10 may display an image, and a user in front of the display 10 may see the image and the rear of the display 10.

At this time, one side of each of the plates 31 facing the display 10 may be painted in white, and the vertical stripes of the plates 31 may be less noticeable to a user in front of the display 10. Alternatively, the one side may be painted in a different color.

If it is determined at S21 that the angle of all the plates 31 is not 0 degree (S21: No), the controller 110 may determine whether the angle of all the plates 31 is 90 degrees (S23). Here, if the angle of all plates 31 is 90 degrees, the rear of the display 10 is covered by the plates 31.

If it is determined at S23 that the angle of all plates 31 is 90 degrees (S23: Yes), the controller 110 may determine that the mode of the display 10 is a light-blocking mode (S24) (see the lower drawing of FIG. 32). The display 10 may or may not display an image, and a user in front of the display 10 may not be able to see the rear of the display 10.

At this time, the other side of each of the plates 31 facing the display 10 may be painted in black, and the color contrast of the image of the display 10 may be improved. Alternatively, the other side may be painted in a different color.

If it is determined at S23 that some of the plates 31 have an angle of 0 degree and the rest have an angle of 90 degrees (S23: No), the controller 110 may determine that the mode of the display 10 is a partial light-blocking mode S25 (see the middle drawing of FIG. 32).

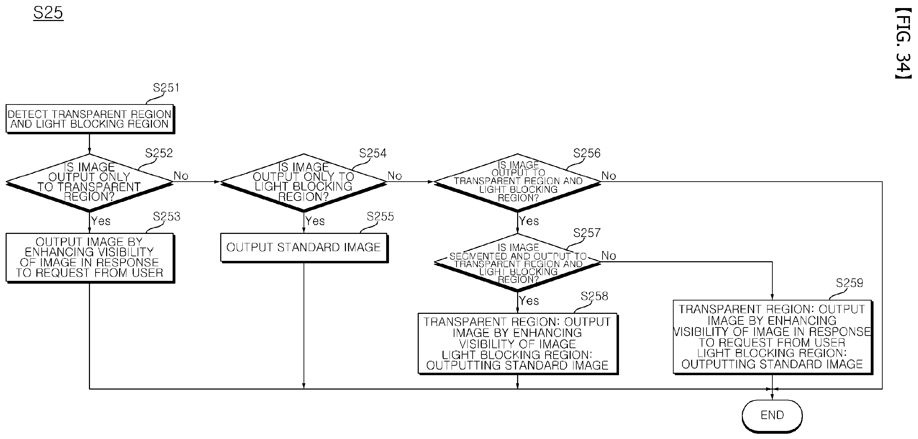

Referring to FIGS. 34 to 36, in a partial light-blocking mode S25, the controller 110 may detect the location of each of the plates 31, based on information obtained from the motor 32 (see FIG. 13) and the sensor 39b (see FIG. 13), and may detect the transparent region SA and the light-blocking region SB S251. The angle of the plates 31 in the transparent region SA is 0 degree, and the angle of the plates 31 in the light-blocking region SB is 90 degrees.

In the case where the image is output only from the transparent region SA (S252: Yes), the controller 110 may enhance the visibility of the image output from the transparent region SA, at the request of a user. For example, the controller 110 may increase the brightness, contrast, sharpness, etc. of the image compared to a standard image in order to enhance the visibility of the image. Here, the standard image is an image having brightness, contrast, sharpness, etc. set based on the light-blocking region SB. Accordingly, the visibility of the image output from the light-blocking region SA may be enhanced.

In the case where the image is output only from the light-blocking region SB (S254: Yes), the controller 110 may output the standard image through the light-blocking region SB (S255).

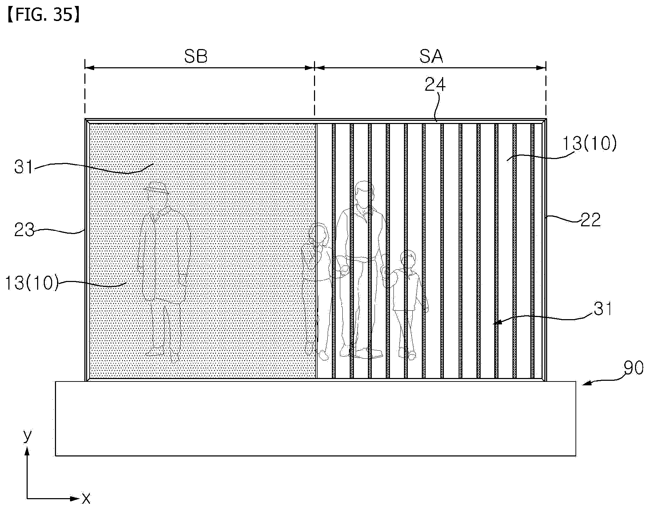

In the case where any one image is divided and output through the transparent region SA and the light-blocking region SB (S257: Yes), the controller 110 may enhance the visibility of the image output from the transparent region SA while outputting a standard image through the light-blocking region SB (see FIG. 35) (S258). For example, the controller 110 may increase the brightness, contrast, sharpness, etc. of the image in the light-blocking region SB compared to the standard image in order to enhance the visibility of the image in the transparent area SA. Accordingly, the sense of incongruity in the image between the transparent region SA and the light-blocking region SB may be reduced. Meanwhile, even in the case (not shown) where the same image is output through each of the transparent region SA and the light-blocking region SB, a control method such as S258 may be performed.

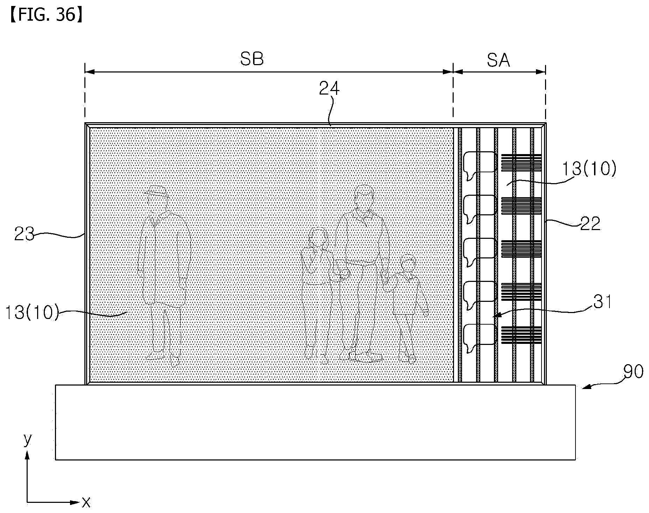

In the case where different images are output through the transparent region SA and the light-blocking region SB respectively (S257: No), the controller 110 may enhance the visibility of the image output from the transparent region SA at the user's request, but output a standard image through the light-blocking region SB (see FIG. 36)(S259). For example, the controller 110 may increase the brightness, contrast, sharpness, etc. of the image compared to the standard image of the light-blocking region SB in order to enhance the visibility of the image of the transparent area SA. Accordingly, a user may enhance the visibility of the image of the transparent region SA, or may not enhance the visibility of the image of the light-blocking region SA. For example, the image of the transparent region SA may be a real-time chat window linked to the image of the light-blocking region SB.

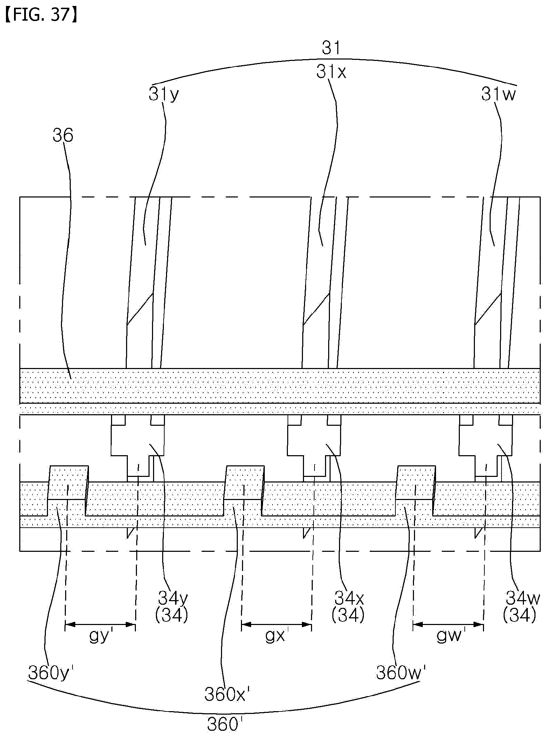

Referring to FIG. 37, a plurality of protrusions 360' may be formed on the inner circumferential surface of the belt 36, and may be alternately arranged with the plurality of wheels 34. The gap between each of the plurality of protrusions 360' and each of the plurality of wheels 34 may be constant (gy'=gx'=gw'). In this case, the plurality of plates 31 may be simultaneously rotated by the plurality of protrusions 360'.

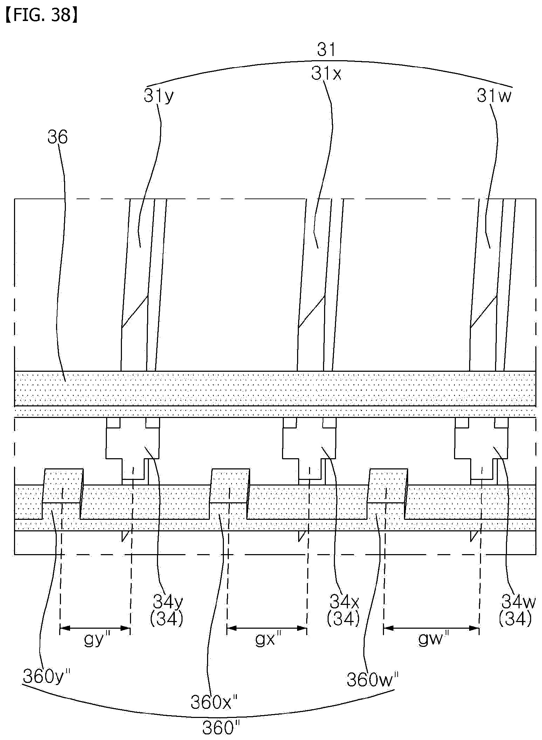

Referring to FIG. 38, a plurality of protrusions 360" may be formed on the inner circumferential surface of the belt 36, and may be alternately arranged with the plurality of wheels 34. The gap between each of the plurality of protrusions 360" and each of the plurality of wheels 34 may increase as they get farther away from the driven pulley 35 (see FIG. 12) (gy"<gx"<gw"). In this case, the plurality of plates 31 may be sequentially rotated from the closest plate to the driven pulley 35 (see FIG. 12) to the farthest plate by the plurality of protrusions 360".

This sequential rotation pattern may be varied by adjusting the gap (gy", gx", gw") between the aforementioned protrusions and wheels.

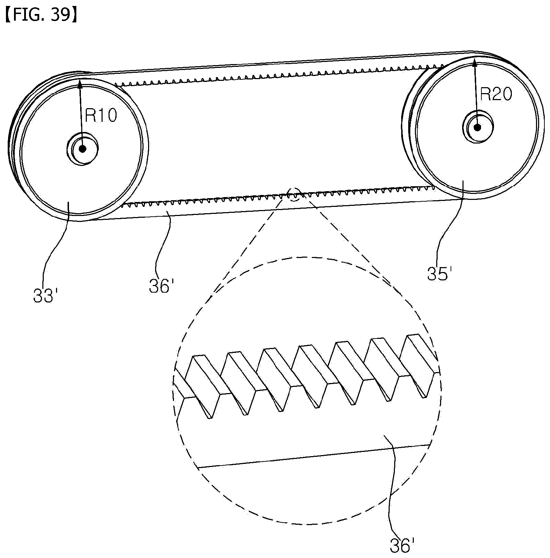

Referring to FIGS. 39 to 44, the drive pulley 33' may include a fixed conical plate 331, a movable conical plate 332, and a shaft 333. The horn of the fixed conical plate 331 may be directed toward the movable conical plate 332, and the horn of the movable conical plate 332 may be directed toward the fixed conical plate 331. The shaft 333 may protrude from the horn of the fixed conical plate 331 toward the movable conical plate 332, and may penetrate the movable conical plate 332.

The fixed conical plate 331 and the movable conical plate 332 may be fixed to the rotation axis 32a, and may rotate together with the rotation axis 32a. In addition, the movable conical plate 332 may be coupled to the shaft 333 so as to be movable in the longitudinal direction of the shaft 333. For example, a power member such as a linear actuator may allow the movable conical plate 332 to reciprocate linearly.

The driven pulley 35' may include a fixed conical plate 351, a movable conical plate 352, and a shaft 353. The horn of the fixed conical plate 351 may be directed toward the movable conical plate 352, and the horn of the movable conical plate 352 may be directed toward the fixed conical plate 351. The shaft 353 may protrude from the horn of the fixed conical plate 351 toward the movable conical plate 352, and may penetrate the movable conical plate 352.

The movable conical plate 352 may be movably coupled to the shaft 353 in the longitudinal direction of the shaft 353. For example, a power member 37, such as a linear actuator, may allow the movable conical plate 352 to reciprocate linearly.

A belt 36' may be spanned between the fixed conical plate 331, 351 and the movable conical plate 332, 352. The belt 36' may be engaged with the drive pulley 33' and the driven pulley 35'. The belt 36' may be a V-belt.

Referring to FIGS. 39 to 41, for example, the movable conical plate 332, 352 may approach the fixed conical plate 331, 351 as close as possible, and a minimum gap D10 may be formed between the movable conical plate 332, 352 and the fixed conical plate 331, 351. The belt 36' may be caught on the conical surface of the movable conical plate 332, 352 and the conical surface of the fixed conical plate 331, 351, and may form a maximum radius (R10, R20) with respect to the shaft 333.

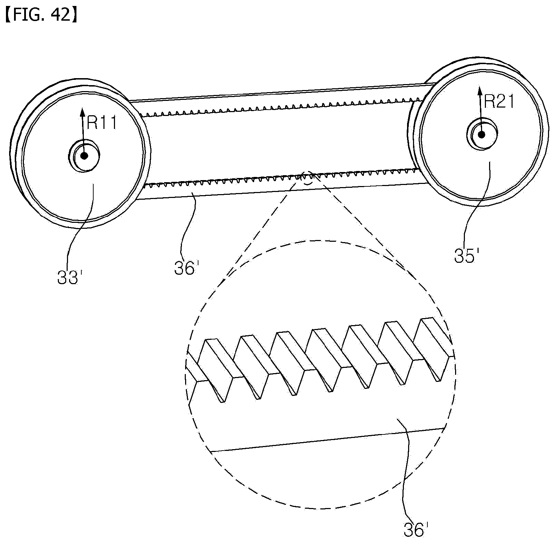

Referring to FIGS. 42 to 44, for example, the movable conical plate 332, 352 may be maximally separated from the fixed conical plate 331, 351, and a maximum gap D11 may be formed between the movable conical plate 332, 352 and the fixed conical plate 331, 351. The belt 36' may be caught on the conical surface of the movable conical plate 332, 352 and the conical surface of the fixed conical plate 331, 351, and may form a minimum radius (R11, R21) with respect to the shaft 333.

Accordingly, the drive pulley 33' and the driven pulley 35' may be referred to as a variable diameter pulley. Meanwhile, it is also possible to implement the variable diameter pulley with a mechanism other than one described above.

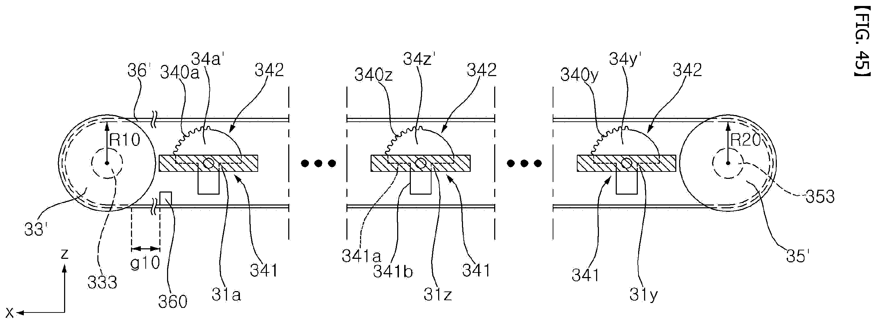

Referring to FIGS. 45 to 47, a first wheel 34a' may be closest to the drive pulley 33', and a twenty-fifth wheel 34y' may be closest to the driven pulley 35'. A intermediate wheel 34z' may be located between the first wheel 34a' and the twenty-fifth wheel 34y', and may be any one of second to twenty-fourth wheels 34b', 34c', 34d', 34e', 34f', 34g', 34h', 34i', 34j', 34k', 34l', 34m', 34n', 34o', 34p', 34q', 34r', 34s', 34t', 34u', 34v', 34w', and 34x'.

The first wheel 34a', the intermediate wheel 34z', and the twenty-fifth wheel 34y' may have an umbrella or mushroom shape overall. The wheel 34a', 34z', 34y' may include a T-shaped stem portion 341 and a dome portion 342. A first side 341a of the stem portion 341 may be a portion that collides with a protrusion 360 (see FIGS. 17 to 25). A second side 341b of the stem portion 341 may be a portion that collides with a protrusion 360 (see FIGS. 26 to 28).

A first gear teeth 340a may be formed on the outer circumferential surface of the dome portion 342 of the first wheel 34a'. The first gear teeth 340a may be located within a range of a certain angle (e.g., 90 degrees) in the circumferential direction of the first wheel 34a'. The first gear teeth 340a may have a shape that engages with a portion (i.e., the inner circumferential surface of the belt 36') of the belt 36' that engages with the drive pulley 33' and the driven pulley 35'.

An intermediate gear teeth 340z may be formed on the outer circumferential surface of the dome portion 342 of the intermediate wheel 34z'. The intermediate gear teeth 340z may be located within a range of a certain angle (e.g., 90 degrees) in the circumferential direction of the intermediate wheel 34z'. The intermediate gear 340z may have a shape that engages with a portion (i.e., an inner circumferential surface of the belt 36') of the belt 36' that engages with the drive pulley 33' and the driven pulley 35'.

A twenty-fifth gear teeth 340y may be formed on the outer circumferential surface of the dome portion 342 of the twenty-fifth wheel 34y'. The twenty-fifth gear teeth 340y may be located within a range of a certain angle (e.g., 90 degrees) in the circumferential direction of the twenty-fifth wheel 34y'. The twenty-fifth gear teeth 340y may have a shape that engages with a portion (i.e., an inner circumferential surface of the belt 36') of the belt 36' that engages with the drive pulley 33' and the driven pulley 35'.

Referring to FIG. 45, the angle of all plates 31a, 31z, and 31y may be 90 degrees, and the radius (R10, R20) of the belt 36' with respect to the shaft 333, 353 may be maximum. At this time, the first gear teeth 340a, the intermediate gear teeth 340z, and the twenty-fifth gear teeth 340y may be spaced from the belt 36'. In this state, when the drive pulley 33' rotates counterclockwise CCW, a first plate 31a, an intermediate plate 31z, and a twenty-fifth plate 31y may be sequentially rotated from 90 degrees to 0 degree.

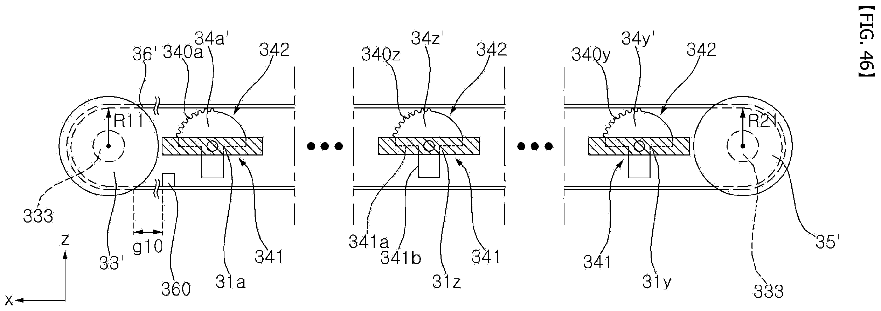

Referring to FIG. 46, the radius (R11, R21) of the belt 36' with respect to the shaft 333, 353 may be minimum. At this time, the first gear teeth 340a, the intermediate gear teeth 340z, and the twenty-fifth gear teeth 340y may contact the belt 36'.

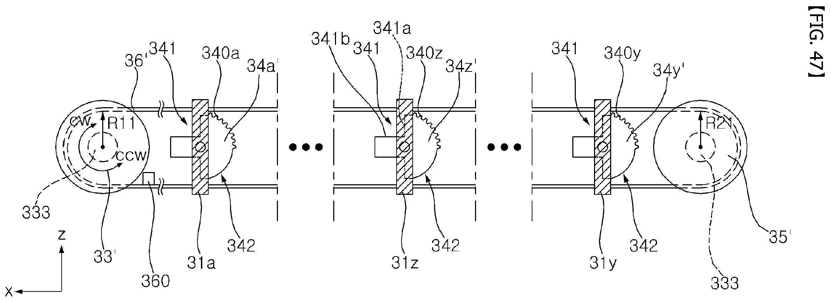

Referring to FIG. 47, when the drive pulley 33' rotates clockwise CW, all the plates 31a, 31z, and 31y may rotate according to the engagement of the gear teeth 340a, 340z, 340y and the belt 36'. Accordingly, all the plates 31a, 31z, 31y may be simultaneously rotated from 90 degrees to 180 degrees. In this state, when the drive pulley 33' rotates counterclockwise CCW, all the plates 31a, 31z, 31y may be simultaneously rotated from 180 degrees to 90 degrees.

Meanwhile, in FIG. 45, the distance g10 between the protrusion 360 and the drive pulley 33' may be greater than the length of the gear teeth 340a, 340z, 340y. Accordingly, during the aforementioned engagement of the gear teeth 340a, 340z, 340y and the belt 36', the protrusion 360 may not contact the drive pulley 33'.

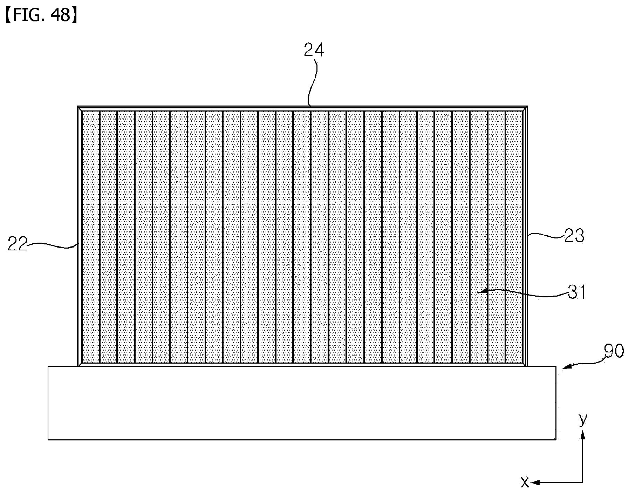

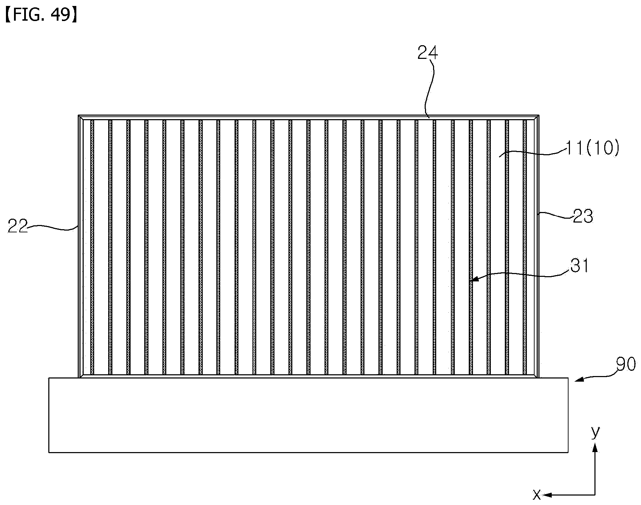

Referring to FIGS. 48 and 49 in order, the plurality of plates 31 may be simultaneously rotated from 90 degrees to 180 degrees, thereby opening the rear of the display panel 11.

Referring to FIGS. 48 and 49 in reverse order, the plurality of plates 31 may simultaneously rotate from 180 degrees to 90 degrees, thereby closing the rear of the display panel 11.

Referring to FIGS. 1 to 49, a display device according to an aspect of the present disclosure includes:
a display panel having a light emitting region and a transparent region; a plurality of plates positioned behind the display panel, extending in one direction, and sequentially arranged in the other direction; and a side frame extending along a periphery of the display panel, and to which each of the plurality of plates is rotatably coupled around a rotation axis parallel to the one direction, wherein the plurality of plates are sequentially rotated along the other direction, and open or close a rear of the display panel, wherein the plurality of plates include: a first plate; and a second plate spaced apart from the first plate in the other direction, wherein a rotation start point of the second plate is later than a rotation end point of the first plate.

The rear of the display panel may be opened through a space between the plurality of plates, when a thickness direction of the plurality of plates is aligned in the other direction, and the rear of the display panel may be closed by the plurality of plates, when the thickness direction of the plurality of plates is aligned in a direction intersecting with the one direction and the other direction.

Each of the plurality of plates may have a cross section of a parallelogram, and a portion of one of the plurality of plates may overlap with a portion of another of the plurality of plates in a front-rear direction, when the rear of the display panel is closed.

Each of the plurality of plates may include: one side facing the rear of the display panel, when the rear of the display panel is closed; and the other side facing the rear of the display panel, when the rear of the display panel is opened, wherein the one side may be white and the other side may be black.

The display device may further include a motor; and a plurality of wheels that receive power from the motor, wherein each of the plurality of wheels may be fixed to the rotation axis of each of the plurality of plates, and may rotate sequentially along the other direction.

The display device may further include: a drive pulley fixed to a rotation axis of the motor; a driven pulley opposite the drive pulley with respect to the plurality of wheels; a belt engaged with the drive pulley and the driven pulley; and a protrusion formed at an inner circumferential surface of the belt, wherein the plurality of wheels may be located on a movement path of the protrusion corresponding to a movement of the belt.

The side frame may include: a top part and a bottom part which are opposite to each other in the one direction; and a left part and a right part which are opposite to each other in the other direction, wherein each of the plurality of plates may include: a top pin protruding from one end of the plate toward the top part, and rotatably coupled to the top part; and a bottom pin protruding from the other end of the plate toward the bottom part, rotatably coupled to the bottom part, and penetrating the bottom part, wherein each of the plurality of wheels may be fixed to a distal end of the bottom pin of each of the plurality of plates.

The display device may further include a first magnet and a second magnet which are provided in an inner side of the top part or an inner side of the bottom part, and which are located around the bottom pin or the top pin, wherein the plate may include a magnetic material, and wherein the first magnet and the second magnet may be spaced apart from each other at 90 degrees with respect to the bottom pin or the top pin.

The protrusion may rotate each of the plurality of wheels by 45 degrees or more.

The wheel may be a cross-shaped wheel, a T-shaped wheel, or an L-shaped wheel.

The drive pulley and the driven pulley may be a variable diameter pulley, each of the plurality of wheels may include: a dome portion; a T-shaped stem portion coupled to a bottom surface of the dome portion; a gear teeth which is formed on an outer circumferential surface of the dome portion, and located within a certain angle range in a circumferential direction of the dome portion, and the gear teeth may have a shape that engages with the inner circumferential surface of the belt, and the gear teeth may be spaced from the inner circumferential surface of the belt when a radius of the belt with respect to a center of the variable diameter pulley is maximum, and the gear teeth may be in contact with the inner circumferential surface of the belt when the radius of the belt with respect to the center of the variable diameter pulley is minimum.

The protrusion may be spaced from the drive pulley or the driven pulley, during an engagement of the gear teeth and the inner circumferential surface of the belt.

The protrusion may include a plurality of protrusions arranged alternately with the plurality of wheels, wherein a gap between each of the plurality of protrusions and each of the plurality of wheels may be constant, or may increase as it gets farther away from the driven pulley.

The display device may further include: a housing located below the display panel; and a drive module which is located in an internal space of the housing, and which rotates the plurality of plates.

The display device may further include: a sensor detecting a rotation angle of the plurality of plates; and a controller determining a light-transmitting mode or a light-blocking mode of the display panel, based on information acquired from the sensor, wherein the controller may enhance a visibility of an image and may outputs the image, when the display panel displays the image in the light-transmitting mode.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings and a configuration "B" described in another embodiment of the disclosure and the drawings may be combined with each other. Namely, although the combination between the configurations is not directly described, the combination is possible except in the case where it is described that the combination is impossible.

The foregoing embodiments are merely examples and are not to be considered as limiting the present disclosure. The scope of the present disclosure should be determined by the appended claims.

## Claims

1. A display device (1) comprising:
a display panel (11) having a light emitting region and a transparent region;
a plurality of plates (31) positioned behind the display panel (11), extending in one direction, and sequentially arranged in the other direction; and
a side frame (20) extending along a periphery of the display panel (11), and to which each of the plurality of plates (31) is rotatably coupled around a rotation axis parallel to the one direction,
**characterised in that**
the plurality of plates (31) are sequentially rotated along the other direction, and open or close a rear of the display panel (11),
wherein the plurality of plates (31) comprise:
a first plate (31a); and
a second plate (31b) spaced apart from the first plate (31a) in the other direction,
wherein a rotation start point of the second plate (31b) is later than a rotation end point of the first plate (31a).

2. The display device (1) of claim 1, wherein the rear of the display panel (11) is opened through a space between the plurality of plates (31), when a thickness direction of the plurality of plates (31) is aligned in the other direction, and
the rear of the display panel (11) is closed by the plurality of plates, when the thickness direction of the plurality of plates is aligned in a direction intersecting with the one direction and the other direction.

3. The display device (1) of claim 1 or 2, wherein each of the plurality of plates (31) has a cross section of a parallelogram, and
a portion of one of the plurality of plates (31) overlaps with a portion of another of the plurality of plates (31) in a front-rear direction, when the rear of the display panel (11) is closed.

4. The display device (1) of any one of claims 1 to 3, wherein each of the plurality of plates comprises:
one side facing the rear of the display panel (11), when the rear of the display panel (11) is closed; and
the other side facing the rear of the display panel (11), when the rear of the display panel (11) is opened,
wherein the one side is white and the other side is black.

5. The display device (1) of any one of claims 1 to 4, further comprising:
a motor (32); and
a plurality of wheels (34) that receive power from the motor (32),
wherein each of the plurality of wheels (34) is fixed to the rotation axis of each of the plurality of plates (31), and rotates sequentially along the other direction

6. The display device (1) of claim 5, further comprising:
a drive pulley (33) fixed to a rotation axis of the motor (32);
a driven pulley (35) opposite the drive pulley (33) with respect to the plurality of wheels (34);
a belt (36) engaged with the drive pulley (33) and the driven pulley (35); and
a protrusion (360) formed at an inner circumferential surface of the belt (36),
wherein the plurality of wheels (34) are located on a movement path of the protrusion (360) corresponding to a movement of the belt (36).

7. The display device (1) of claim 6, wherein the side frame (20) comprises:
a top part (24) and a bottom part (21) which are opposite to each other in the one direction; and
a left part (22) and a right part (23) which are opposite to each other in the other direction,
wherein each of the plurality of plates (31) comprises:
a top pin (312) protruding from one end of the plate (31) toward the top part (24), and rotatably coupled to the top part (24); and
a bottom pin (311) protruding from the other end of the plate (31) toward the bottom part (21), rotatably coupled to the bottom part (21), and penetrating the bottom part (21),
wherein each of the plurality of wheels (34) is fixed to a distal end of the bottom pin (311) of each of the plurality of plates (31).

8. The display device (1) of claim 7, further comprising a first magnet (24m) and a second magnet (24n) which are provided in an inner side of the top part (24) or an inner side of the bottom part (21), and which are located around the bottom pin (311) or the top pin (312),
wherein the plate (31) comprises a magnetic material, and
wherein the first magnet (24m) and the second magnet (24n) are spaced apart from each other at 90 degrees with respect to the bottom pin (311) or the top pin (312).

9. The display device (1) of any one of claims 6 to 8, wherein the protrusion (360) rotates each of the plurality of wheels (34) by 45 degrees or more.

10. The display device (1) of any one of claims 6 to 9, wherein the wheel (34) is a cross-shaped wheel, a T-shaped wheel, or an L-shaped wheel.

11. The display device (1) of any one of claims 6 to 10, wherein the drive pulley (33) and the driven pulley (35) are a variable diameter pulley,
wherein each of the plurality of wheels (34) comprises:
a dome portion (342);
a T-shaped stem portion (341) coupled to a bottom surface of the dome portion (342);
a gear teeth which is formed on an outer circumferential surface of the dome portion (342), and located within a certain angle range in a circumferential direction of the dome portion (342),
wherein the gear teeth has a shape that engages with the inner circumferential surface of the belt (36'),
wherein the gear teeth is spaced from the inner circumferential surface of the belt (36') when a radius of the belt (36') with respect to a center of the variable diameter pulley is maximum, and
wherein the gear teeth is in contact with the inner circumferential surface of the belt (36') when the radius of the belt (36') with respect to the center of the variable diameter pulley is minimum.

12. The display device (1) of claim 11, wherein the protrusion (360) is spaced from the drive pulley (33') or the driven pulley (35'), during an engagement of the gear teeth and the inner circumferential surface of the belt (36').

13. The display device (1) of claim 6, wherein the protrusion comprises a plurality of protrusions (360'; 360") arranged alternately with the plurality of wheels (34),
wherein a gap between each of the plurality of protrusions (360'; 360") and each of the plurality of wheels (34) is constant, or increases as it gets farther away from the driven pulley (35).

14. The display device (1) of any one of claims 1 to 13, further comprising:
a housing (90) located below the display panel (11); and
a drive module which is located in an internal space of the housing (90), and which rotates the plurality of plates (31).

15. The display device (1) of any one of claims 1 to 14, further comprising:
a sensor (39b) detecting a rotation angle of the plurality of plates (31); and
a controller (110) determining a light-transmitting mode or a light-blocking mode of the display panel, based on information acquired from the sensor (39b),
wherein the controller (110) enhances a visibility of an image and outputs the image, when the display panel (11) displays the image in the light-transmitting mode.

## Patentansprüche

1. Anzeigevorrichtung (1), umfassend:
ein Anzeigepanel (11) mit einem lichtemittierenden Bereich und einem transparenten Bereich;
eine Vielzahl von Platten (31), die hinter dem Anzeigepanel (11) positioniert sind, sich in einer Richtung erstrecken und in der anderen Richtung sequenziell angeordnet sind; und
einen Seitenrahmen (20), der sich entlang eines Umfangs des Anzeigepanels (11) erstreckt und mit dem jede der Vielzahl von Platten (31) um eine zu der einen Richtung parallele Drehachse drehbar gekoppelt ist,
**dadurch gekennzeichnet, dass** die Vielzahl von Platten (31) sequenziell entlang der anderen Richtung gedreht werden und eine Rückseite des Anzeigepanels (11) öffnen oder schließen,
wobei die Vielzahl von Platten (31) umfassen:
eine erste Platte (31a); und
eine zweite Platte (31b), die von der ersten Platte (31a) in der anderen Richtung beabstandet ist,
wobei ein Drehstartpunkt der zweiten Platte (31b) später als ein Drehendpunkt der ersten Platte (31a) ist.

2. Die Anzeigevorrichtung (1) nach Anspruch 1, wobei die Rückseite des Anzeigepanels (11) durch einen Raum zwischen der Vielzahl von Platten (31) geöffnet ist, wenn eine Dickenrichtung der Vielzahl von Platten (31) in der anderen Richtung ausgerichtet ist, und
die Rückseite des Anzeigepanels (11) durch die Vielzahl von Platten verschlossen ist, wenn die Dickenrichtung der Vielzahl von Platten in einer Richtung ausgerichtet ist, die die eine Richtung und die andere Richtung schneidet.

3. Die Anzeigevorrichtung (1) nach Anspruch 1 oder 2, wobei jede der Vielzahl von Platten (31) einen Querschnitt in Form eines Parallelogramms aufweist und
ein Abschnitt einer der Vielzahl von Platten (31) einen Abschnitt einer anderen der Vielzahl von Platten (31) in einer Vorder-Hinter-Richtung überlappt, wenn die Rückseite des Anzeigepanels (11) geschlossen ist.

4. Die Anzeigevorrichtung (1) nach einem der Ansprüche 1 bis 3, wobei jede der Vielzahl von Platten umfasst:
eine Seite, die der Rückseite des Anzeigefelds (11) zugewandt ist, wenn die Rückseite des Anzeigepanels (11) geschlossen ist; und
eine andere Seite, die zur Rückseite des Anzeigefelds (11) zeigt, wenn die Rückseite des Anzeigepanels (11) geöffnet ist,
wobei die eine Seite weiß und die andere Seite schwarz ist.

5. Die Anzeigevorrichtung (1) nach einem der Ansprüche 1 bis 4, die ferner umfasst:
einen Motor (32); und
eine Vielzahl von Rädern (34), die vom Motor (32) angetrieben werden,
wobei jedes der Vielzahl von Räder (34) an der Drehachse jeder der Vielzahl von Platten (31) befestigt ist und sich nacheinander in die andere Richtung dreht.

6. Die Anzeigevorrichtung (1) nach Anspruch 5, die ferner umfasst:
eine Antriebsriemenscheibe (33), die an einer Drehachse des Motors (32) befestigt ist;
eine angetriebene Riemenscheibe (35), die in Bezug auf die Vielzahl von Räder (34) gegenüber der Antriebsriemenscheibe (33) angeordnet ist;
einen Riemen (36), der mit der Antriebsriemenscheibe (33) und der angetriebenen Riemenscheibe (35) in Eingriff steht; und
einen Vorsprung (360), der an einer Innenumfangsfläche des Riemens (36) ausgebildet ist,
wobei sich die Vielzahl von Räder (34) auf einem Bewegungsweg des Vorsprungs (360) befinden, der einer Bewegung des Riemens (36) entspricht.

7. Die Anzeigevorrichtung (1) nach Anspruch 6, wobei der Seitenrahmen (20) umfasst:
ein Oberteil (24) und ein Unterteil (21), die einander in einer Richtung gegenüberliegen; und
ein linkes Teil (22) und ein rechtes Teil (23), die einander in der anderen Richtung gegenüberliegen,
wobei jede der Vielzahl von Platten (31) umfasst:
einen oberen Stift (312), der von einem Ende der Platte (31) in Richtung des oberen Teils (24) vorsteht und drehbar mit dem oberen Teil (24) verbunden ist; und
einen unteren Stift (311), der aus dem anderen Ende der Platte (31) in Richtung des unteren Teils (21) herausragt, drehbar mit dem unteren Teil (21) verbunden ist und das untere Teil (21) durchdringt,
wobei jedes der Vielzahl von Räder (34) an einem distalen Ende des unteren Bolzens (311) jeder der Vielzahl von Platten (31) befestigt ist.

8. Die Anzeigevorrichtung (1) nach Anspruch 7, die ferner einen ersten Magneten (24m) und einen zweiten Magneten (24n) umfasst, die an einer Innenseite des oberen Teils (24) oder einer Innenseite des unteren Teils (21) vorgesehen sind und sich um den unteren Stift (311) oder den oberen Stift (312) herum befinden,
wobei die Platte (31) ein magnetisches Material umfasst und
wobei der erste Magnet (24m) und der zweite Magnet (24n) in einem Winkel von 90 Grad zueinander in Bezug auf den unteren Stift (311) oder den oberen Stift (312) angeordnet sind.

9. Anzeigevorrichtung (1) nach einem der Ansprüche 6 bis 8, wobei der Vorsprung (360) jedes der Vielzahl von Räder (34) um 45 Grad oder mehr dreht.

10. Die Anzeigevorrichtung (1) nach einem der Ansprüche 6 bis 9, wobei das Rad (34) ein kreuzförmiges Rad, ein T-förmiges Rad oder ein L-förmiges Rad ist.

11. Die Anzeigevorrichtung (1) nach einem der Ansprüche 6 bis 10, wobei die Antriebsrolle (33) und die angetriebene Rolle (35) eine Rolle mit variablem Durchmesser sind,
wobei jedes der Vielzahl von Räder (34) umfasst:
einen gewölbten Abschnitt (342);
einen T-förmigen Schaftabschnitt (341), der mit einer Unterseite des Kuppelabschnitts (342) verbunden ist;
ein Zahnrad, das an einer Außenumfangsfläche des Kuppelabschnitts (342) ausgebildet ist und sich innerhalb eines bestimmten Winkelbereichs in Umfangsrichtung des Kuppelabschnitts (342) befindet,
wobei die Zahnräder eine Form aufweisen, die mit der Innenumfangsfläche des Riemens (36') in Eingriff steht,
wobei die Zahnradzähne von der inneren Umfangsfläche des Riemens (36') beabstandet sind, wenn ein Radius des Riemens (36') in Bezug auf die Mitte der Riemenscheibe mit variablem Durchmesser maximal ist, und
wobei die Zahnradzähne mit der inneren Umfangsfläche des Riemens (36') in Kontakt stehen, wenn der Radius des Riemens (36') in Bezug auf den Mittelpunkt der Riemenscheibe mit variablem Durchmesser minimal ist.

12. Die Anzeigevorrichtung (1) nach Anspruch 11, wobei der Vorsprung (360) während eines Eingriffs der Zahnräder und der Innenumfangsfläche des Riemens (36') von der Antriebsriemenscheibe (33') oder der angetriebenen Riemenscheibe (35') beabstandet ist.

13. Die Anzeigevorrichtung (1) nach Anspruch 6, wobei der Vorsprung eine Vielzahl von Vorsprüngen (360'; 360") umfasst, die abwechselnd mit der Vielzahl von Rädern (34) angeordnet sind,
wobei ein Abstand zwischen jedem der Vielzahl von Vorsprünge (360'; 360") und jedem der Vielzahl von Räder (34) konstant ist oder mit zunehmender Entfernung von der angetriebenen Riemenscheibe (35) zunimmt.

14. Die Anzeigevorrichtung (1) nach einem der Ansprüche 1 bis 13, die ferner umfasst:
ein Gehäuse (90), das sich unterhalb der Anzeigeplatte (11) befindet; und
ein Antriebsmodul, das sich in einem Innenraum des Gehäuses (90) befindet und die Vielzahl von Platten (31) dreht.

15. Die Anzeigevorrichtung (1) nach einem der Ansprüche 1 bis 14, die ferner umfasst:
einen Sensor (39b), der einen Drehwinkel der Vielzahl von Platten (31) erfasst; und
eine Steuereinheit (110), die auf der Grundlage der vom Sensor (39b) erfassten Informationen einen lichtdurchlässigen Modus oder einen lichtundurchlässigen Modus des Anzeigepanels bestimmt,
wobei die Steuereinheit (110) die Sichtbarkeit eines Bildes verbessert und das Bild ausgibt, wenn das Anzeigepanel (11) das Bild im lichtdurchlässigen Modus anzeigt.

## Revendications

1. Dispositif d'affichage (1), comprenant:
un écran d'affichage (11) comportant une région lumineuse et une région transparente;
une pluralité de plaques (31) positionnées derrière l'écran d'affichage (11), s'étendant dans une direction et disposées séquentiellement dans l'autre direction; et
un cadre latéral (20) s'étendant le long d'une périphérie de l'écran d'affichage (11), et auquel chaque plaque de la pluralité de plaques (31) est accouplée en rotation autour d'un axe de rotation parallèle à la première direction,
**caractérisé en ce que** la pluralité de plaques (31) sont tournées séquentiellement dans l'autre sens et ouvrent ou ferment l'arrière de l'écran d'affichage (11),
dans lequel la pluralité de plaques (31) comprend:
une première plaque (31a); et
une deuxième plaque (31b) espacée de la première plaque (31a) dans l'autre sens,
dans lequel le point de départ de la rotation de la deuxième plaque (31b) est postérieur au point d'arrivée de la rotation de la première plaque (31a).

2. Dispositif d'affichage (1) selon la revendication 1, dans lequel l'arrière de l'écran d'affichage (11) est ouvert par un espace entre la pluralité de plaques (31), lorsque la direction d'épaisseur de la pluralité de plaques (31) est alignée dans l'autre direction, et
l'arrière de l'écran d'affichage (11) est fermé par la pluralité de plaques, lorsque la direction d'épaisseur de la pluralité de plaques est alignée dans une direction qui croise la première direction et la deuxième direction.

3. Dispositif d'affichage (1) selon la revendication 1 ou 2, dans lequel chaque plaque de la pluralité de plaques (31) présente une section transversale en parallélogramme, et
une partie d'une plaque parmi la pluralité des plaques (31) chevauche une partie d'une autre plaque parmi la pluralité des plaques (31) dans le sens avant-arrière, lorsque l'arrière de l'écran d'affichage (11) est fermé.

4. Dispositif d'affichage (1) selon l'une quelconque des revendications 1 à 3, dans lequel chaque plaque de la pluralité de plaques comprend:
un côté faisant face à l'arrière de l'écran d'affichage (11), lorsque l'arrière de l'écran d'affichage (11) est fermé; et
l'autre côté faisant face à l'arrière de l'écran d'affichage (11), lorsque l'arrière de l'écran d'affichage (11) est ouvert,
dans lequel ledit côté est blanc et ledit autre côté est noir.

5. Dispositif d'affichage (1) selon l'une quelconque des revendications 1 à 4, comprenant en outre:
un moteur (32); et
une pluralité de roues (34) qui reçoivent la puissance du moteur (32),
dans lequel chaque roue de la pluralité des roues (34) est fixée à l'axe de rotation de chaque plaque de la pluralité des plaques (31) et tourne séquentiellement dans l'autre sens.

6. Dispositif d'affichage (1) selon la revendication 5, comprenant en outre:
une poulie d'entraînement (33) fixée à un axe de rotation du moteur (32);
une poulie entraînée (35) en regard de la poulie d'entraînement (33) par rapport à la pluralité de roues (34);
une courroie (36) en prise avec la poulie d'entraînement (33) et la poulie entraînée (35); et
une saillie (360) formée sur une surface circonférentielle interne de la courroie (36),
dans lequel la pluralité de roues (34) sont situées sur un trajet de déplacement de la saillie (360) correspondant à un déplacement de la courroie (36).

7. Dispositif d'affichage (1) selon la revendication 6, dans lequel le cadre latéral (20) comprend:
une partie supérieure (24) et une partie inférieure (21) qui se font face dans une direction; et
une partie gauche (22) et une partie droite (23) qui se font face dans l'autre direction,
dans lequel chaque plaque de la pluralité des plaques (31) comprend:
une tige supérieure (312) dépassant d'une extrémité de la plaque (31) en direction de la partie supérieure (24) et accouplée en rotation à la partie supérieure (24); et
une tige inférieure (311) dépassant de l'autre extrémité de la plaque (31) en direction de la partie inférieure (21), accouplée en rotation à la partie inférieure (21); et entrant dans la partie inférieure (21),
dans lequel chaque roue de la pluralité des roues (34) est fixée à une extrémité distale de la tige inférieure (311) de chaque plaque de la pluralité des plaques (31).

8. Dispositif d'affichage (1) selon la revendication 7, comprenant en outre un premier aimant (24m) et un deuxième aimant (24n) qui sont disposés dans une face interne de la partie supérieure (24) ou dans une face interne de la partie inférieure (21), et qui sont situés autour de la tige inférieure (311) ou de la tige supérieure (312).
dans lequel la plaque (31) comprend un matériau magnétique, et
dans lequel le premier aimant (24m) et le deuxième aimant (24n) sont espacés l'un de l'autre à 90 degrés par rapport à la tige inférieure (311) ou à la tige supérieure (312).

9. Dispositif d'affichage (1) selon l'une quelconque des revendications 6 à 8, dans lequel la saillie (360) fait tourner chaque roue de la pluralité des roues (34) de 45 degrés ou plus.

10. Dispositif d'affichage (1) selon l'une quelconque des revendication 6 à 9, dans lequel la roue (34) est une roue en forme de croix, une roue en forme de T ou une roue en forme de L.

11. Dispositif d'affichage (1) selon l'une quelconque des revendication 6 à 10, dans lequel la poulie d'entraînement (33) et la poulie entraînée (35) sont des poulies à diamètre variable,
dans lequel chaque roue de la pluralité de roues (34) comprend:
une partie en forme de dôme (342);
une partie de tige en forme de T (341) accouplée à une surface inférieure de la partie en forme de dôme (342);
une denture qui est formée sur une surface circonférentielle extérieure de la partie en forme de dôme (342) et située dans une certaine plage angulaire dans une direction circonférentielle de la partie en forme de dôme (342),
dans lequel la denture a une forme qui s'engrène avec la surface circonférentielle interne de la courroie (36').
dans lequel la denture est espacée de la surface circonférentielle intérieure de la courroie (36') lorsque le rayon de la courroie (36') par rapport au centre de la poulie à diamètre variable est maximal, et
dans lequel la denture est en contact avec la surface circonférentielle intérieure de la courroie (36') lorsque le rayon de la courroie (36') par rapport au centre de la poulie à diamètre variable est minimal.

12. Dispositif d'affichage (1) selon la revendication 11, dans lequel la saillie (360) est espacée de la poulie d'entraînement (33') ou de la poulie entraînée (35'), pendant un l'engrènement de la denture et de la surface circonférentielle intérieure de la courroie (36').

13. Dispositif d'affichage (1) selon la revendication 6, dans lequel la saillie comprend une pluralité de saillies (360' ; 360") disposées en alternance avec la pluralité de roues (34),
dans lequel l'espace entre chaque saillie de la pluralité des saillies (360'; 360") et chaque roue de la pluralité des roues (34) est constant ou augmente à mesure qu'il s'éloigne de la poulie entraînée (35).

14. Dispositif d'affichage (1) selon l'une quelconque des revendications 1 à 13, comprenant en outre:
un boîtier (90) situé sous l'écran d'affichage (11); et
un module de commande qui est situé dans un espace interne du boîtier (90) et qui fait tourner la pluralité de plaques (31).

15. Dispositif d'affichage (1) selon l'une quelconque des revendications 1 à 14, comprenant en outre:
un capteur (39b) détectant un angle de rotation de la pluralité des plaques (31); et
un dispositif de commande (110) déterminant un mode de transmission de la lumière ou un mode de blocage de la lumière de l'écran d'affichage, sur la base des informations acquises par le capteur (39b),
dans lequel le dispositif de commande (110) améliore la visibilité d'une image et délivre l'image, lorsque l'écran d'affichage (11) affiche l'image en mode de transmission de la lumière.
